(19) Europäisches Patentamt
European Patent Office
Office européen des brevets

(11) **EP 1 388 594 B1**

(12) **EUROPÄISCHE PATENTSCHRIFT**

(45) Veröffentlichungstag und Bekanntmachung des Hinweises auf die Patenterteilung:
**06.01.2010 Patentblatt 2010/01**

(51) Int Cl.:
*C23C 16/515* *(2006.01)*    *C23C 16/30* *(2006.01)*
*C23C 16/40* *(2006.01)*    *B65D 65/42* *(2006.01)*
*C23C 28/00* *(2006.01)*

(21) Anmeldenummer: **03017419.7**

(22) Anmeldetag: **01.08.2003**

(54) **Verfahren zum Herstellen von glatten Barriereschichten und Verbundmaterial mit glatter Barriereschicht**

Composite material with smooth barrier layer and process for its production

Matériau composite avec une couche barrière lisse et procédé de sa production

(84) Benannte Vertragsstaaten:
**AT BE BG CH CY CZ DE DK EE ES FI FR GB GR HU IE IT LI LU MC NL PT RO SE SI SK TR**

(30) Priorität: **07.08.2002 PCT/EP02/08853**
         **13.12.2002 DE 10258681**

(43) Veröffentlichungstag der Anmeldung:
**11.02.2004 Patentblatt 2004/07**

(73) Patentinhaber: **Schott AG**
**55122 Mainz (DE)**

(72) Erfinder:
- **Bicker, Matthias, Dr.**
 **55126 Mainz (DE)**
- **Behle, Stephan, Dr.**
 **55278 Hahnheim (DE)**
- **Lüttringhaus-Henkel, Andreas**
 **64289 Darmstadt (DE)**
- **Arnold, Gregor**
 **55294 Bodenheim (DE)**
- **Rothaar, Uwe, Dr.**
 **67161 Gönnheim (DE)**
- **Klause, Michaela**
 **55286 Wörrstadt (DE)**
- **Klippe, Lutz**
 **65187 Wiesbaden (DE)**
- **Walther, Marten**
 **55270 Engelstadt (DE)**

(74) Vertreter: **Herden, Andreas F.**
**Blumbach - Zinngrebe**
**PatentConsult**
**Patentanwälte**
**Alexandrastrasse 5**
**65187 Wiesbaden (DE)**

(56) Entgegenhaltungen:
EP-A- 0 451 618      EP-A- 1 070 971
WO-A-01/94448      DE-A- 19 634 795
US-A- 5 437 725      US-A- 5 718 967
US-A1- 2002 090 521

- WALTHER; HEMING M; SPALLEK M; M: "Multilayer barrier coating system produced by plasma-impulse chemical vapor deposition (PICVD)" SURFACE AND COATINGS TECHNOLOGY, Bd. 80, Nr. 1-2, 31. März 1996 (1996-03-31), XP005717206
- DENNLER G; HOUDAYER A; SÉGUI Y; WERTHEIMER M R: "Growth and structure of hyperthin SiO2 coatings on polymers" JOURNAL OF VACUUM SCIENCE AND TECHNOLOGY A. VACUUM, SURFACES AND FILMS, Bd. 19, Nr. 5, 30. September 2001 (2001-09-30), XP012005805
- WINTER C; WECKENMANN U; FISCHER R A; KASHAMMER J; SCHEUMANN V; MITTLER S: "Selective nucleation and area-selective OMCVD of gold on patterned self-assembled organic monolayers studied by AFM and XPS: a comparison of OMCVD and PVD" CHEMICAL VAPOR DEPOSITION, Bd. 6, Nr. 4, Seiten 199-205, XP000963600

**Beschreibung**

Die Erfindung betrifft allgemein die Herstellung von Barriereschichten mittels plasmaunterstützer CVD-Abscheidung und im speziellen ein Verfahren zum Aufbringen von Schichten auf ein Substrat, wobei auf dem Substrat zumindest eine organische Haftvermittlerschicht abgeschieden wird, sowie ein Verbundmaterial mit einer organischen Haftvermittlerschicht.

Besonders auf dem Gebiet der Verpackungstechnik und auch auf dem Gebiet medizinischer Geräte besteht ein ständig steigendes Interesse an Polymersubstraten, welche mit zumindest einer Barriereschicht beschichtet sind. Glasähnliche Barriereschichten, die Siliziumoxid enthalten, sind in diesem Zusammenhang besonders interessant, weil diese mehrere wünschenswerte Eigenschaften aufweisen. So sind diese zum Beispiel transparent, recykelbar und für den Gebrauch in Mikrowelleneinrichtungen geeignet. In dieser Hinsicht sind glasähnliche Barriereschichten dünnen Metallschichten, wie sie derzeit kommerziell auf verschiedenen Polymersubstraten aufgebracht werden, hochgradig überlegen.

Für eine effiziente Herstellung von Barriereschichten auf dielektrischen Materialien ist es jedoch notwendig, glatte Schichten mit geringer Dichte an inneren Grenzflächen oder anderen Inhomogenitäten abzuscheiden. Eine hohe Dichte an topologischen oder chemischen Homogenitäten kann zu einer erhöhten Permeation führen. Dies ist vor allem dann der Fall, wenn kurze Diffusionspfade entlang der Inhomogenitäten vorhanden sind, durch die im Vergleich zum Volumen eine schnelle Diffusion ablaufen kann. Zum Beispiel lässt sich mit sehr porösen Schichten keine hohe Sperrwirkung erzielen. Anorganische glähnliche Barriereeinzelschichten haben den Nachteil, dass sie sehr spröde werden und dadurch unter Dehnungsbelastung anfällig gegen Rissbildung sind. Dieser Aspekt spielt bei flexiblen Substraten eine wichtige Rolle. Ferner haften anorganische Barriereeinzelschichten nicht optimal auf polymeren Substraten, weil beispielsweise zwischen einer $SiO_x$-Schicht und einem PET-Substrat nur geringe Bindungsenergien vorliegen.

Um die Haftung von Silikonoxidfilmen auf unterschiedlichen Polymersubstraten zu verbessern, ist aus Rupertus et al., Fresenius J Anal Chem (1997) 358, S. 85-88, bekannt, das Substrat vor der Beschichtung in einem Sauerstoffplasma zu behandeln. Um neben einer verbesserten Haftung die Permeabilität der Barriereschichten verringern zu können, sollte die Oberfläche möglichst glatt sein. In Erlat et al., J. Mater. Res., (2000) 15, S. 704-716 und Erlat et al., J. Phys. Chem. B (1999), 103, S. 6047-6055 wird die Morphologie von anorganischen $SiO_x$-Einzelschichten auf Kunststofffolien im Zusammenhang mit deren Barrierewirkung diskutiert sowie der Einfluss diverser Prozessparameter auf die Morphologie der Schichten untersucht.

Die Beschichtungen aus einem Polymer, welches Si, O, C und H enthält, können bekanntermaßen auf dem Substrat aus einem Plasma abgeschieden werden. Ein solches Verfahren ist beispielsweise in US 5,298,587 beschrieben. US 5,718,967 betrifft eine Beschichtung auf einem Kunststoffsubstrat, für die zunächst eine Haftvermittlerschicht im wesentlichen unter Ausschluss von Sauerstoff, und dann unter Sauerstoffüberschuss eine Schutzschicht aus einem Plasma abgeschieden werden. Die Leistungsdichte liegt nach diesen Verfahren zwischen $10^6$ J/kg und $10^8$ J/kg und ist damit relativ hoch.

Neben den vorstehend genannten Verfahren zur Beschichtung von Kunststofffolien wird in WO 02/09891 A1 und WO 02/10473 A1 das Abscheiden einer $SiO_x$-Barriereschicht bzw. einer $SiO_x$-Barriereschicht, welche mit einem amorphen Kohlenwasserstoffschutzfilm beschichtet ist, beschrieben, wobei die Beschichtung auf einer Seite eines Hohlkörpers aufgebracht wird.

Um eine optimale Barriereschicht auf flexiblen Substraten, insbesondere Polymeren, herzustellen, reicht es jedoch nicht aus, lediglich die Morphologie einer einzelnen anorganischen Barriereschicht auf einem Kunststoffsubstrat zu betrachten und lediglich diese sehr glatt abzuscheiden. Erforderlich ist es, zunächst eine glatte organische Haftvermittlerschicht abzuscheiden. Zusätzlich muss weiterhin auf der glatten Haftvermittlerschicht eine ebenfalls möglichst glatte und dichte Barriereschicht aufgebracht werden.

Erst die Kombination aus glattem Haftvermittler und glatter Barriereschicht ermöglicht die Realisierung eines haft- und dehnfähigen Verbundes mit hoher Barrierewirkung. Ist zum Beispiel die Haftvermittlerschicht zu rauh, so kann auf dieser keine glatte anorganische Barriereschicht mit hoher Sperrwirkung mehr aufgebracht werden, auch wenn die Prozessparameter so eingestellt sind, dass eine einzelne anorganischen Barriereschicht ohne Haftvermittler auf dem gleichen unbeschichteten Substrat sehr glatt aufwachsen würde.

Neben der Rauhigkeit der Schichten muss auch die Dichte an inneren Grenzflächen im Hinblick auf die Diffusionspfade in Betracht gezogen werden. Zur Vereinfachung des Verfahren ist es zudem wünschenswert, alle Schichten generell in Anwesenheit von Sauerstoff abscheiden zu können und auch Stickstoff als Bestandteil der Schichten zulassen zu können. Des Weiteren sollten nicht nur das Beschichten von Folien oder Hohlkörpern auf einer ihrer Seiten, sondern insbesondere das Beschichten beliebiger Hohlkörper und auch beider Seiten eines Hohlkörpers ermöglicht werden.

Für eine ideale Barrierebeschichtung wird dabei Folgendes gefordert: das Substrat sollte, abgesehen von kleinen "pinholes", mit einer vollständig geschlossenen Schicht bedeckt werden, wobei die Rauhigkeit der Beschichtung gegenüber dem unbeschichteten Substrat nurgeringfügig zunimmt.

Experimentelle Untersuchungen der Erfinder konnten mit der Modellvorstellung in Einklang gebracht werden, dass Schichten, die sehr rauh aufwachsen und eine hohe Dichte an inneren Grenzflächen haben, kurze Diffusionswege entlang dieser Schichten ermöglichen. Im Extremfall könnten sogar bestimmte Bereiche unbeschichtet sein, während in anderen Bereichen hohe Inseln oder Wachstumssäulen auftreten.

Derartiges Verhalten tritt bei kinetisch gehemmten Prozessbedingungen auf, so zum Beispiel bei geringer Oberflächentemperatur der Teilchen, geringer Oberflächenenergie bei zu hohem Prozessdruck.

Eine gute Barriereschicht sollte dagegen bezogen auf das Substrat relativ glatt sein. Sie sollte dadurch möglichst wenig innere Grenzflächen, vor allem senkrecht zum Substrat, aufweisen. Dadurch können nach Erkenntnissen der Erfinder die Diffusionswege deutlich verlängert und die Permeation durch das beschichtete Substrat gegenüber dem unbeschichteten stark reduziert werden.

Für die Betrachtung der Rauhigkeit der Schichten ist zu beachten, dass vom Substrat eine Grundrauhigkeit vorgegeben ist. Zur Charakterisierung der Beschichtung ist daher nicht die absolute Rauhigkeit, sondern die Änderung der Rauhigkeit gegenüber dem unbeschichteten Substrat entscheidend. Generell tritt häufig beim Schichtwachstum durch Abschattungseffekte eine Zunahme der Rauhigkeit("kinetic roughening") auf.

Bei CVD-Prozessen können aber auch durch Volumenreaktionen Partikel gebildet werden, die teilweise auf dem Substrat abgeschieden werden können und dort eine sehr rauhe Struktur verursachen.

Neben der Zunahme der Rauhigkeit durch die Beschichtung als Merkmale der Schichtmorphologie können die Wachstumsmode und die Dichte an inneren Grenzflächen betrachtet werden. Wird die Wachstumsmode während des Beschichtungsvorgangs beibehalten, kann ein Lagenwachstum, Säulenwachstum oder Inselwachstum (Volmer-Weber-Mode) während der gesamten Beschichtung stattfinden.

Daneben ist denkbar, dass die Beschichtung zunächst im Lagenwachstum und anschließend im Inselwachstum (Stranski-Krastanov-Mode) oder zuerst im Lagenwachstum und dann im Säulenwachstum erfolgt.

Die Charakterisierung der Dichte an Imhomogenitäten kann zum Beispiel mittels Querschliffpräparation und Rasterelektronenmikroskopie erfolgen. Dabei ist häufig nur eine Aussage für einen lokal sehr kleinen Bereich der Probe aufweisen. Dadurch können nach Erkenntnissen der Erfinder die Diffusionswege deutlich verlängert und die Permeation durch das beschichtete Substrat gegenüber dem unbeschichteten stark reduziert werden.

Für die Betrachtung der Rauhigkeit der Schichten ist zu beachten, dass vom Substrat eine Grundrauhigkeit vorgegeben ist. Zur Charakterisierung der Beschichtung ist daher nicht die absolute Rauhigkeit, sondern die Änderung der Rauhigkeit gegenüber dem unbeschichteten Substrat entscheidend. Generell tritt häufig beim Schichtwachstum durch Abschattungseffekte eine Zunahme der Rauhigkeit("kinetic roughening") auf.

Bei CVD-Prozessen können aber auch durch Volumenreaktionen Partikel gebildet werden, die teilweise auf dem Substrat abgeschieden werden können und dort eine sehr rauhe Struktur verursachen.

In der EP 0 451 618 A1 wird ein Verfahren zum Herstellen optischer Interferenzbeschichtungen beschrieben. Bei dem Verfahren zur Herstellung dieser Beschichtungen werden zwei Materialien A, B simultan in sich verändernde Verhältnissen aufgebracht, um ein Brechungsindexprofil des aufgebrachten Filmes einzustellen. Dabei werden übliche Prozessschritte wie Evakuieren einer Prozesskammer, Einstellen eines Temperaturausgleichs, Ausgasenlassen einer Probe, Zünden eines Plasmas, Verwenden eines Plasmas zur Reinigung einer Probe, Einführen eines Trägergases oder Hinzufügen eines Reaktionsgases offenbart. Diese sind aber allein auf ein Einstellen des Brechungsindexprofils der optischen Schichten beschränkt.

Neben der Zunahme der Rauhigkeit durch die Beschichtung als Merkmale der Schichtmorphologie können die Wachstumsmode und die Dichte an inneren Grenzflächen betrachtet werden. Wird die Wachstumsmode während des Beschichtungsvorgangs beibehalten, kann ein Lagenwachstum, Säulenwachstum oder Inselwachstum (Volmer-Weber-Mode) während der gesamten Beschichtung stattfinden.

Daneben ist denkbar, dass die Beschichtung zunächst im Lagenwachstum und anschließend im Inselwachstum (Stranski-Krastanov-Mode) oder zuerst im Lagenwachstum und dann im Säulenwachstum erfolgt.

Von M. Walther, M. Heming und M. Spallek ist in Surface and Coatings Technology Bd. 80, 1996, S. 200 ein durch chemische Abscheidung aus der Dampfphase mit Plasma-Impuls-Unterstützung (PICVD- Plasma-Impulse Chemical Vapor Deposition) hergestelltes Beschichtungssystem beschrieben. Das als Mehrschicht-Beschichtung bezeichnete System hält einer erhöhten mechanischen Belastung stand und weist eine bessere Temperaturstabilität auf. Bei der Herstellung wird ein Precursor von einem Mikrowellenpuls aktiviert.

In J. Vac. Sci. Technology A19, 2001, S. 2320 wird von G. Dennier et al. Für dünnen $SiO_2$-Beschichtungen ein Lagenwachstum bei einer Einstellung eines Precursors von 10 % beschrieben, wobei als Precursor Hexamethyldisiloxan (HMDSO) verwendet wird. Es wird auch ausgeführt, unter welchen Bedingungen ein Lagenwachstum nach dem sogenannten "Frank-van der Merwe-Modus" erfolgt.

Die Charakterisierung der Dichte an Imhomogenitäten kann zum Beispiel mittels Querschliffpräparation und Rasterelektronenmikroskopie erfolgen. Dabei ist häufig nur eine Aussage für einen lokal sehr kleinen Bereich der Probe möglich. Auch Aufsicht-REM-Aufnahmen ermöglichen eine Charakterisierung der Strukturgrößen, wie zum Beispiel der Durchmesser von clusterähnlichen Hügelstrukturen oder von Körnern. Außerdem kann die Dichte an inneren Grenzflächen, wie zum Beispiel Korngrenzen, dargestellt werden. Zur Darstellung der Topographie wird auf den Schichten eine sehr dünne leitfähige Schicht aufgebracht. Die Dichte an Inhomogenitäten einer mit dem erfindungsgemäßen Verfahren hergestellten Beschichtung ist derart gering, dass an der gesamten Oberfläche oder in betrachteten Teilbereichen keine oder nur wenige (d.h. max. 200 auf einer Fläche von $1\mu m^2$) konstrastbildende Strukturen oder Partikel mit einer Strukturgröße beziehungsweise einem Durchmesser von mehr als 50 nm vorhanden sind, die durch die Beschichtung erzeugt worden sind.

Mit anderen Methoden wie der Atomic Force Microscopy (AFM) oder der Weißlichtinterferometrie (WLI) kann die Schichtrauhigkeit ermittelt werden. Beispielsweise kann die Rauigkeit mit der Weißlichtinterferometrie folgendermaßen bestimmt werden. Die Rauigkeit wird über eine gesamte Fläche mit einer Seitenlänge von beispielsweise $50\mu m$ gemessen und der Unterschied zwischen einem unbeschichteten und einem beschichteten Substrat bestimmt. Vorteilhafterweise erfolgt diese Bestimmung auf planaren Substraten. Falls Hohlkörper relevant sind, können kleine Proben aus diesem entnommen werden. Besser ist es jedoch, die Beschichtung eines planaren Substrats mit dem gleichen Prozess durchzuführen, wobei jenes Substrat aus demselben Material wie der Hohlkörper bestehen muss.

Das erfindungsgemäße Verfahren ermöglicht das Aufbringen von Beschichtungen, bei denen die Rauigkeit gegenüber dem unbeschichteten Substrat abnimmt, gleich bleibt oder maximal um eine halbe Schichtdicke, vorzugsweise um 20 % der Schichtdicke, zunimmt.

In vielen Fällen weisen sehr glatte Schichten eine deutlich geringere Dichte an Inhomogenitäten auf, so dass indirekt über die Rauhigkeit der Schichten auf Barrierewirkung rückgeschlossen werden kann.

Zum Beispiel kommt es für Multilayerschichten aus organischen und anorganischen Schichten auf eine geringe Rauhigkeit an. Ist bereits eine der unteren Schichten sehr rauh, kann die nächste Schicht nicht mehr glatt aufwachsen. Dadurch kann eine Barrierewirkung einer Einzelschicht sogar zerstört werden, wenn diese auf einer rauhen Schicht aufgebracht wird.

Ein weiterer wichtiger Faktor ist das Substrat: auf einem rauhen Substrat lassen sich glatte Schichten nur schwer oder überhaupt nicht abscheiden, sofern es nicht gelingt, durch eine erste Vorbeschichtung einen glättenden Effekt zu erzielen, bevor eine glatte Barriereschicht aufgebracht wird.

Zur Bestimmung der Schichtzusammensetzung, insbesondere des Kohlenstoffgehalts, sind XPS-Messungen geeignet. Dazu wird eine Einzelschicht definierter Dicke auf einem Substrat abgeschieden und anschließend die Konzentration der vorhandenen chemischen Elemente vermessen.

Aus den vorstehend beschriebenen Umständen ergibt sich daher die Aufgabe der Erfindung, optimal haftende und glatte, aus einem Plasma abgeschiedene Barriereschichten auf einem Substrat bereitzustellen, die zu einer hohen Barrierewirkung führen und die gut auf dem Substrat haften und beständig unter Dehnungsbelastung und/oder plastischer Verformung und/oder Temperaturbelastung sind.

Gelöst wird diese Aufgabe bereits durch die Merkmale des Anspruchs 1, sowie einem Verbundmaterial gemäß Anspruch 21

Vorteilhafte Weiterbildungen finden sich in den jeweils zugeordneten Unteransprüchen.

Die erfindungsgemäße Lösung stellt damit erstmals ein Verfahren zur Verfügung, mit dem es gelingt, sehr glatte Einzel- oder Multilayerschichten auf einem Substrat, wie insbesondere einem Kunststoffsubstrat abzuscheiden. Die beschichteten Substrate haben eine Rauhigkeit, die nur geringfügig größer als die vom Substrat selbst vorgegebene Rauhigkeit ist. Durch die geringe Rauhigkeit der Schichten wird auch bei sehr dünnen Schichten eine sehr gute Barrierewirkung erzielt. Bei Wechselschichten wird die Diffusion durch die Grenzflächen zwischen organischen und anorganischen Schichten gehemmt, bzw. der Diffusionsweg deutlich verlängert.

Durch geeignet gewählte Prozessparameter können sowohl sehr glatte anorganische als auch sehr glatte organische Schichten abgeschieden werden, die eine sehr hohe Massendichte besitzen und nur eine geringe Dichte an inneren Grenzflächen oder anderen topologischen und/oder chemischen Inhomogenitäten oder Defekten aufweisen.

Während bestimmte Prozessparameter zu einer Abscheidung von glatten Schichten führen, wird bei einer Einstellung von ungünstigen anderen Prozessparametern die Beschichtung sehr rauh abgeschieden.

An den Beschichtungsprozess wird die Anforderung gestellt, das Substrat zunächst vollständig mit einer ersten organischen Schicht zu bedecken, das bedeutet ein anfängliches Lagenwachstum istoptimal. Dabei muss die erste organische Schicht hinreichend glatt sein, so dass es möglich wird, auf dieser ersten Schicht noch eine glatte zweite Schicht aufzubringen.

Bei dem erfindungsgemäßen Verfahren zum Aufbringen von Schichten auf ein Substrat wird ein Plasma eingesetzt, das insbesondere unter Verwendung von Mikrowellen in einer Gasatmosphäre erzeugt wird. Auf dem Substrat wird vor dem Abscheiden zumindest einer weiteren Schicht zumindest eine organische Haftvermittlerschicht abgeschieden.

Die Gasatmosphäre umfaßt dazu vorteilhaft zumindest einen Precursor, der an der Bildung von Reaktionsprodukten im Plasma beteiligt ist, die sich als Beschichtung auf dem Substrat abscheiden. Besonders geeignet als Precursor sind unter anderem Organosilizidverbindungen, wie beispielsweise Hexamethyldisilazan (HMDSN) oder Hexamethyldisiloxan (HMDSO). Selbstverständlich sind auch andere Precursorverbindungen für die plasmaunterstützte CVD-Beschichtung geeignet, wobei die Wahl der Zusammensetzung des Precursors auch von der zu erreichenden Schichtzusammensetzung abhängt. Darüber hinaus können auch mehrere Precursoren gemischt werden. Beispielsweise ist eine Mischung aus zwei verschiedenen siliziumhaltigen Precursoren, beispielsweise HMDSO und HMDSN denkbar.

Die Gasatmosphäre kann beispielsweise nur aus dem reinen Precursor zusammengesetzt sein, um bestimmte Schichtzusammensetzungen zu erreichen. Beispielsweise kann das Abscheiden einer organischen Haftvermittlerschicht in reiner Precursor-Gasatmosphäre vorgenommen werden. Die Gasatmosphäre kann jedoch auch vorteilhaft weitere Komponenten, wie zumindest ein Trägergas und/oder zumindest ein Reaktivgas umfassen. Als Reaktivgas ist insbesondere Sauerstoff geeignet, der im Plasma mit dem Precursor reagieren kann. Ein Trägergas ist unter anderem zum Zünden und zur Aufrechterhaltung des Plasmas, sowie als Träger für den Transport der zum Teil nur schwerflüchtigen PrecursorVerbindungen vorteilhaft. Geeignet als Trägergase sind unter anderem Edelgase. Auch stickstoffhaltige Gase können verwendet werden, wobei Stickstoff allerdings vielfach auch als reaktive Komponente an den Reaktionen im Plasma beteiligt ist und in den abgeschiedenen Schichten eingebaut wird.

In der früheren PCT-Anmeldung WO 03014415 der Anmelderin, wird die Grundidee einer Haftvermittlerschicht zwischen einem Substrat und auf die Haftvermittlerschicht folgenden Beschichtungen beschrieben. Beschichtungen aus einer Haftvermittlerschicht und darauffolgenden weiteren Schichten können z.B. durch Änderung der Prozessparameter während des Beschichtungsvorgangs hergestellt werden. Das zu beschichtende Substratmaterial kann auch einen Hohlkörper umfassen. Im Rahmen der vorliegenden Erfindung wird das Prinzip des Aufbringens einer Haftvermittlerschicht für eine Beschichtung im Hinblick auf die Morphologie des gesamten Schichtsystems weiterentwickelt.

Vorteilhafterweise wächst die Haftvermittlerschicht erfindungsgemäß zumindest in den ersten Monolagen im Lagenwachstum auf.

Die erste organische Barriereschicht wird im Folgenden als Haftvermittlerschicht bezeichnet. Es ist jedoch zu beachten, dass sie neben der verbesserten Haftung eines Mehrschichtverbunds auf dem Substrat die Dehnfähigkeit und mechanische Belastbarkeit des Schichtverbunds verbessert: unter Dehnbelastung und/oder plastischer Verformung wird eine Rissbildung durch den gesamten Verbund stärker gehemmt bzw. sogar verhindert, wenn eine derartige organische Haftvermittlerschicht eingesetzt wird. Dadurch werden nach dem sogenannten "Creep-Test" bessere Resultate als bei anorganischen Einzelschichten erzielt.

Durch die Abscheidung der Schicht im Lagenwachstum, bei dem eine im wesentlichen vollständige Bedeckung der Substratoberfläche stattfindet, können die bevorzugten sehr glatten Barriereschichten realisiert werden. Dagegen sind andere Wachstumsstrukturen häufig mit einer größeren Porosität der Schichten verbunden, denn sie weisen eine größerer Anzahl innere Grenzflächen auf. Bei Säulen- oder Inselwachstum ist die Oberfläche häufig rauher und es gibt eine größere Anzahl kürzerer Diffusionswege innerhalb der Beschichtung. Derartige Wachstumsmoden können vorteilhaft für andere Zielrichtungen eingesetzt werden.

So sieht die Erfindung vor, nach dem Aufbringen der organischen Haftvermittlerschicht im wesentlichen durch einen Wechsel der Gaskonzentration und/oder einen Wechsel des Prozessdrucks und/oder einen Wechsel Precursorflusses und/oder reinen Wechsel des Reaktivgasflusses kontinuierlich oder stufenförmig einen Wechsel vom Lagenwachstum zum Säulenwachstum durchzuführen. Durch die Wachstumsstruktur kann eine weitere Stabilisierung des Schichtverbundes erfolgen. Wird ein Wechsel vom Lagenwachstum zum Säulenwachstum durchgeführt, ist dieser Verbund im Vergleich zu einer reinen im Lagenwachstum abgeschiedenen Schicht mechanisch stabilisiert, denn die Kräfte innerhalb der Grenzflächen zwischen den einzelnen Säulen bewirken eine Stabilisierung gegenüber Dehnungsbelastungen.

Auch durch ein Wechsel von einer organischen zu einer anorganischen Schicht bzw. umgekehrt entstehen Grenzflächen, welche in besonders vorteilhafter Weise parallel zur Substratoberfläche angeordnet sind. Bei derartigen Wechselschichten wird deswegen die Diffusion durch die Grenzflächen deutlich gehemmt bzw. der Diffusionsweg signifikant verlängert. Um diese Vorteile umsetzen zu können, sieht die Erfindung vor, zusätzlich zu einer organischen Schicht zumindest eine weitere Schicht abzuscheiden, welche anorganisch ist. Durch den Schichtverbund aus organischer und anorganischer Schicht wird eine besonders gute Barrierewirkung gegen Sauerstoff, Kohlendioxid, Wasserdampf und/oder andere Substanzen, insbesondere gegen Acetaldehyd und andere anorganische und/oder organische Gase erzielt.

Durch die verbesserte Barrierewirkung wird zudem eine verlängerte Haltbarkeit des in einen entsprechend beschichteten Behälter eingefüllten Produkts erzielt. Dies ist mit einem geringeren Abbau wertvoller Inhaltsstoffe wie beispielsweise Vitaminen bei Lebensmitteln verbunden. Auch die Farbe des Produkts ist geringeren Änderungen unterworfen. Sensorische Tests belegen darüber hinaus, dass der Geschmack des Produkts längere Zeit erhalten bleibt und deutlich weniger verändert wird. Des Weiteren bleibt der Druck in einem solchen Behälter länger erhalten. Es entstehen weniger Abbauprodukte aus Reaktionen des Behälterinhalts mit in den Behälter eintretenden Gasen. Zudem werden weniger Substanzen aus dem Inhalt und/oder Substanzen, die bei der Befüllung verwendet werden, in der Behälterwandung aufgenommen.

Das Herstellen glatter Barriereschichten erfolgt erfindungsgemäß in vorteilhafter Weise durch das Einstellen der Prozessparameter auf solche Werte, die im Zusammenspiel aller Prozessparameter das Abscheiden der gewünschten Schichtenmorphologie ermöglichen. Beim Abscheiden einer organischen Schicht, wie insbesondere der organischen Haftvermittlerschicht liegt daher die Precursorkonzentration erfindungsgemäß im Bereich von 5 bis 99%, bevorzugt von 10 bis 60 %. Eine Precursorkonzentration innerhalb dieses Bereichs kann jedoch selbstverständlich auch für das Abscheiden weiterer organischer Schichten in einem mehrlagigen Schichtverbund verwendet werden. Beim Abscheiden einer anorganischen Schicht, die beispielsweise als zumindest eine weitere Schicht auf der organischen Haftvermittlerschicht aufgebracht wird, liegt die Precursorkonzentration vorteilhaft im Bereich von 0,5 bis 5 %, bevorzugt im Bereich von 0,8 bis 3 %. Der Prozessdruck liegt beim Abscheiden der organischen Schicht im Bereich von 0,1 bis 1 mbar und bevorzugt im Bereich von 0,2 bis 0,6 mbar. Beim Abscheiden der anorganischen Schicht liegt der Prozessdruck erfindungsgemäß im Bereich von 0,1 bis 1 mbar, bevorzugt im Bereich von 0,2 bis 0,6 mbar. Die untere Grenze für den Prozessdruck wird dabei dadurch bestimmt, dass bei zu geringem Druck die Abscheiderate für die anorganischen Schichten zu gering wird und dass allgemein das Plasma eine gewisse Gasdichte benötigt, um noch gezündet werden zu können. Liegt der Prozessdruck dagegen deutlich oberhalb von 1 mbar, besteht die Gefahr, dass durch eine Volumenabscheidung viele große Partikel entstehen, die auch auf dem Substrat niedergeschlagen werden können, so dass gerade keine glatten Schichten mehr aufgebracht werden können.

Der Gesamtfluss beträgt beim Abscheiden einer organischen Schicht, wie insbesondere der organischen Haftvermittlerschicht 10 bis 1000 sccm, bevorzugt liegt der Gesamtfluss im Bereich von 30 bis 500 sccm. Beim Abscheiden der anorganischen Schicht liegt der Gesamtfluss im Bereich von 50 bis 1000 sccm, bevorzugt im Bereich von 100 bis 500 sccm.

Die Erfindung sieht vor, ein gepulstes Plasma einzusetzen. Ein gepulstes Plasma hat gegenüber einem kontinuierlichen Plasma den Vorteil, daß in den Pulspausen ein guter Austausch des verwendeten Prozeßgases ermöglicht wird und sich so nur wenige unerwünschte Reaktionsprodukte im Plasma anreichern können. Außerdem wird durch Beschichtung mit einem gepulsten Plasma, beziehungsweise durch PICVD-Beschichtung (PICVD = "Plasma Impulse Chemical Vapor Deposition") eine starke Aufheizung des Substrats vermieden, so daß dieses Verfahren insbesondere auch bei wenig temperaturstabilen Substraten, wie etwa Kunststoffsubstraten problemlos eingesetzt werden kann. Außerdem können durch die zusätzlichen Größen der Pulsdauer, Pulspause und Pulsleistung zusätzliche Prozessparameter beeinflußt werden, was eine vielseitige Prozeßsteuerung ermöglicht. Es ist jedoch auch möglich, ein "Continuous Wave-" (CW-) Plasma zu benutzen. Wird ein gepulstes Plasma eingesetzt, liegt erfindungsgemäß die Pulsdauer beim Abscheiden einer organischen Schicht, wie insbesondere der organischen Haftvermittlerschicht im Bereich von 0,05 bis 5 ms, bevorzugt im Bereich von 0,1 bis 1 ms. Die Pulsdauer beträgt beim Abscheiden der anorganischen Schicht 1 bis 50 ms, bevorzugt liegt sie im Bereich von 2 bis 20 ms.

Beim Abscheiden einer organischen Schicht, wie insbesondere der organischen Haftvermittlerschicht beträgt die Pulspause 2 bis 100 ms, bevorzugt beträgt der Wert 5 bis 60 ms. Die Pulspause beim Abscheiden einer anorganischen Schicht liegt im Bereich von 5 bis 200 ms und bevorzugt im Bereich von 10 bis 100 ms. Die Pulsleistung liegt erfindungsgemäß im Bereich von 100 bis 4500 W, bevorzugt im Bereich von 400 bis 2000 W.

Durch das erfindungsgemäße Verfahren wird es vorteilhafterweise möglich, die erforderliche mittlere Leistungsdichte $P_M$ zu senken. Die Leistungsdichte ist dabei nach Gleichung 1 definiert:

$$P_M = \frac{\overline{W}}{\sum_i F_i \cdot \tilde{M}_i} \qquad \text{Gleichung 1}$$

mit der mittleren Leistung $\overline{W}$ gemäß Gleichung 2

$$\overline{W} = \frac{\Delta t_{pd}}{\Delta t_{pd} + \Delta t_{pp}} \cdot W_P \qquad \text{Gleichung 2}$$

mit

$P_M$ : Leistungsdichte
$\overline{W}$ : mittlere Mikrowellenleistung
$F_i$ : Fluss der Komponente i, Komponenten: $O_2$, Precursor, Trägergas
$\tilde{M}_i$ : Molekularmasse der Komponente i
$\Delta t_{pb}$ : Pulsdauer
$\Delta t_{pt}$ : Pulspause

$W_p$:     Pulsleistung.

Die Leistungsdichte ist auch näher in der WO 194448 erläutert. Allerdings betrifft diese Erläuterung CW-Plasmen. Daher kann nur die mittlere Leistung eines gepulsten Plasmas mit demjenigen der WO 194448 verglichen werden. Aus Gleichung 1 ergibt sich, dass das Volumen des Reaktors bzw. des Feldes und die Behandlungszeit nicht berücksichtigt werden.

Die mittlere Leistungsdichte beim Abscheiden einer organischen Schicht, wie beispielsweise der Haftvermittlerschicht liegt im Bereich von $1 \cdot 10^3$ J/kg bis $5 \cdot 10^7$ J/kg, bevorzugt im Bereich von $5 \cdot 10^5$ J/kg bis $5 \cdot 10^7$ J/kg.

Beim Abscheiden einer anorganischen Schicht liegt die mittlere Leistungsdichte im Bereich von $4 \cdot 10^3$ J/kg bis $4 \cdot 10^9$ J/kg, bevorzugt im Bereich von $1 \cdot 10^6$ J/kg bis $2 \cdot 10^8$ J/kg.

Die Beschichtungszeit liegt beim Abscheiden von organischen Schichten im Bereich von 0,05 s bis 20 s, bevorzugt im Bereich von 0,2 s bis 4 s. Die Beschichtungszeit bei anorganischen Schichten beträgt 0,1 s bis 60 s, bevorzugt 0,4 s bis 6 s.

Vorteilhafterweise liegt das Rezipientenvolumen erfindungsgemäß im Bereich von 10 ml bis 2000 ml, bevorzugt im Bereich von 30 bis 1000 ml. Dabei bildet das Substrat in der Beschichtungsvorrichtung den Rezipienten.

Vorteilhafterweise kann zum Abscheiden der organischen wie auch der anorganischen Schicht erfindungsgemäß als Reaktivgas Sauerstoff eingesetzt werden. Das Trägergas kann Helium und/oder Argon und/oder Xenon umfassen. Dadurch, dass unterschiedlichste Precursorgase in dem erfindungsgemäßen Verfahren eingesetzt werden können, kann je nach Anforderung eine geeignete Verbindung für das Schichtmaterial synthetisiert werden. Die Erfindung sieht daher vor, zumindest einen Precursor aus der Gruppe auszuwählen, welche organische siliziumhaltige Verbindungen, insbesondere HMDSN, HMDSO, TMDSO, Silan in $N_2$, TEOS oder Siliziumchlorid enthält.

In Hinblick auf die Kombination der Precursorgase und der Reaktiv- bzw. Trägergase ist das erfindungsgemäße Verfahren vorteilhafterweise äußerst variabel: für die einzelnen Schichten können zum einen verschiedene Precursorgase eingesetzt werden.

Für die einzelnen Schichten kann aber auch jeweils der gleiche Precursor eingesetzt werden. Ein schnelles Verfahren zum Aufbringen von Barrierebeschichtungen wird in diesem Zusammenhang in der am selben Tag wie die vorliegende Anmeldung eingereichten deutschen Anmeldung der Anmelderin mit dem Titel "Schnelles Verfahren zur Herstellung von Multilayer-Barrierreschichten" beschrieben, deren Offenbarungsgehalt vollumfänglich in die vorliegende Anmeldung mitaufgenommen wird. Ebenso können für die einzelnen Schichten verschiedene Reaktivgase eingesetzt werden bzw. die einzelnen Schichten aus dem gleichen Reaktivgas abgeschieden werden. Die Precursor und/oder die Reaktivgase können gegebenenfalls für die einzelnen Schichten separat zugeführt werden. In diesem Fall ist es möglich, besonders schnell die Gaswechsel vorzunehmen, wobei definierte Flüsse eingestellt und mit den verschiedenen Precursorgasen für die einzelnen Schichten unterschiedliche Verbindungen synthetisiert werden können. Zudem ist es möglich, den Gaswechsel zwischen zwei Schichten derart durchzuführen, dass während einer Übergangszeit ein Gasgemisch aus Prozessgasen für die vorangegangene und die folgende Schicht entsteht. Je nach gegebenen Anforderungen an die Beschichtung kann erfindungsgemäß auf diese Weise eine Übergangsschicht realisiert werden.

Mit dem erfindungsgemäßen Verfahren wird es möglich, auf dem Substrat vorteilhafterweise einen Verbund aus einer Haftvermittlerschicht und zumindest einer weiteren Schicht herzustellen, dessen Oberflächenrauigkeit höchstens geringfügig größer als die vom Substrat selbst vorgegebene Rauhigkeit ist. Im Hinblick auf den Verbund ist nicht allein die durch die Haftvermittlerschicht verbesserte Haftung der Beschichtung auf dem Substrat entscheidend, da gerade bei rauhen Schichten und rauhen Substraten die Haftung gut sein kann. Vielmehr ist wichtig, dass durch den Verbund die Diffusionswege stark verlängert werden, und der Verbund entsprechend dicht und glatt ist bzw. möglichst wenige "pinholes" aufweist. Falls der Verbund glatt und vollständig über das Substrat verteilt ist, kann dieser bei einer Dehnungsbelastung oder sogar bei plastischer Verformung des Substrats die hohen mechanischen Spannungen in den Schichten abpuffern. Vor allem können Risse ausgehend vom Substrat in die Grenzflächen der Schichten laufen, so dass kein vollständiger Riss bis zur Oberfläche der Schicht auftritt.

Mit dem erfindungsgemäßen Verfahren wird es möglich auf dem Substrat ein Verbund aus Haftvermittlerschicht und zumindest einer weiteren Schicht herzustellen, welcher nach einer mechanischen Belastung mit lokalen Dehnungen von mehr als 3%, vorzugsweise mehr als 4%, und/oder plastischen Verformungen des Substrats und damit verbundenen Dehnungen der Schichten um mehr als 3%, vorzugsweise mehr als 4% eine Barriereverbesserung gegenüber dem unbeschichteten Substrat mit einem Barriereverbesserungsfaktor größer als 1,5, vorzugsweise größer als 2,0 aufweist.

Das Beschichten eines Hohlkörpers als Substrat auf der Innen- und/oder Außenseite wird durch eine Vorrichtung ermöglicht, welche derart ausgebildet ist, dass zum Aufbringen von Wechselschichten auf ein Substrat insbesondere nach einem vorstehend beschriebenen Verfahren zumindest eine Beschichtungseinrichtung mit zumindest einer Halteeinrichtung für ein Substrat, zumindest einer Einrichtung zum Evakuieren der zumindest einen Beschichtungseinrichtung, zumindest eine Einrichtung zum Zuführen eines Gasstroms in die zumindest eine Beschichtungseinrichtung und zumindest eine Einrichtung zum Erzeugen eines Plasmas in der zumindest einen Beschichtungseinrichtung vorgesehen ist.

Als Substrat kann ein Hohlkörper in der Halteeinrichtung derart gehalten werden, dass der Innenraum des Substrats sich an einen ersten Behandlungsraum der Beschichtungseinrichtung anschließen kann, und die Außenseite des Substrats in einen zweiten Behandlungsraum hineinragen kann.

Um die Gasatmosphäre aus Precursor, Reaktivgas und Trägergas zur Verfügung zu stellen, ist vorgesehen, dass die Einrichtung zum Zuführen eines Gasstroms einen Anschluss zu einem Gaserzeuger aufweist. Der Gaserzeuger umfasst Vorratsbehälter für den Precursor und/oder das Reaktivgas und/oder das Trägergas. Je nach Anforderungen an die Schicht kann das Verfahren, wie vorstehend beschrieben, auf unterschiedliche Weise durchgeführt werden. Um dies zu ermöglichen, kann der Gaserzeuger jeweils für jede aufzubringende Schicht Vorratsbehälter für den Precursor und/oder das Reaktivgas und/oder das Trägergas aufweisen, wobei die Vorratsbehälter an jeweils einen Massenflussregler angeschlossen werden können. Die Vorratsbehälter werden mit den Massenflussreglern dann an zumindest einem Mischpunkt angeschlossen, von dem eine Leitung zu einer Beschichtungseinrichtung führen kann, wobei die Leitung mit einem Ventil verbindbar ist. Durch diese Anordnung können die Gase schnell gewechselt werden, wobei die Durchflussraten definiert eingestellt werden können und unterschiedliche Kombinationen aus verschiedenen Precursoren mit den Träger- und Reaktivgasen möglich sind.

Wie vorstehend beschrieben, wird das gezielte Herstellen der gewünschten Morphologie der Schichten durch das erfindungsgemäße Einstellen der Prozessparameter auf die vorstehend beschriebenen Werte ermöglicht. Um diese Werte gezielt einstellen zu können, ist eine Steuerung der Prozessparameter vorgesehen. Die Steuerung der Prozessparameter wird dadurch realisiert, dass die Vorrichtung zumindest eine Einrichtung zum Steuern der Konzentration des Precursors und/oder eine Einrichtung zum Steuern der Konzentration des Reaktivgases und/oder eine Einrichtung zum Steuern der Konzentration des Trägergases umfasst. Ferner weist die Vorrichtung zumindest eine Einrichtung zum Steuern des Prozessdrucks auf. Zudem weist die Vorrichtung vorteilhaft eine Steuereinrichtung auf, welche zumindest eine Einrichtung zum Steuern der mittleren Leistungsdichte und/oder zumindest eine Einrichtung zum Steuern der Pulsdauer und/oder zumindest eine Einrichtung zum Steuern der Pulspause und/oder zumindest eine Einrichtung zum Steuern der Pulsleistung umfasst.

Vorteilhafterweise kann die Vorrichtung in einer Mehrplatzanlage implementiert werden. Eine derartige Mehrplatzanlage weist dementsprechend zumindest zwei Vorrichtungen, wie sie vorstehend beschrieben sind, auf. Mehrplatzanlagen, die für den Einsatz der Vorrichtung, beziehungsweise zur Durchführung des erfindungsgemäßen Verfahrens geeignet sind, werden beispielsweise in der früheren deutschen Anmeldung DE 10224934 der Anmelderin, sowie der PCT-Anmeldung WO 03015122 beschrieben.

Organische Sperrschichten besitzen in der Regel eine geringere Barrierewirkung als anorganische Sperrschichten, die mit optimalen Prozessparametern hergestellt werden.

Der Verbund aus einer organischen und einer anorganischen Sperrschicht hat sich jedoch als besonders vorteilhaft erwiesen. Daher betrifft die Erfindung des Weiteren ein Verbundmaterial, welches ein Substrat und eine Wechselschicht, beziehungsweise einem Schichtverbund umfaßt, wobei die Wechselschicht eine organische Haftvermittlerschicht und zumindest eine weitere Schicht, welche vorzugsweise anorganisch ist, umfaßt.

Um den erfindungsgemäßen Schichtverbund herzustellen, muss die organische Sperrschicht sehr glatt aufgebracht werden. Anschließend wird auf dieser Schicht eine anorganische Sperrschicht abgeschieden, die ebenfalls sehr glatt aufwächst. Der Schichtverbund mit organischer und anorganischer Schicht besitzt eine deutlich höhere Barrierewirkung als eine einzelne anorganische Barriereschicht, die auf dem gleichen Substrat abgeschieden wurde, obwohl eine einzelne organische Schicht für sich alleine genommen keine hohe Barrierewirkung besitzt. Die glatte organische Schicht besitzt in Kombination mit einer glatten anorganischen Schicht vielmehr eine barriereverstärkende Funktion aufgrund von Synergieeffekten. Durch die eingebrachte zusätzliche Grenzfläche wird der Diffusionsweg verlängert und die Permeation kann insbesondere durch veränderte Bindungsverhältnisse in der organischanorganischen Grenzfläche gehemmt werden. Hinzu kommt eine verbesserte Haftung der Schichten und eine höhere mechanische Stabilität gegenüber Dehnungen des Substrats, wodurch eine Rissbildung vermieden werden kann.

Ein mit dem erfindungsgemäßen Verfahren herstellbares Verbundmaterial zeichnet sich außerdem neben der glatten Oberfläche der Beschichtung durch eine hohe Dichte der auf dem Substrat abgeschiedenen Schichten aus. Diese weisen darüber hinaus eine sehr niedrige Dichte von Inhomogenitäten auf. Die glatte Haftvermittlerschicht verleiht, wie oben bereits ausgeführt wurde, zudem dem Schichtverbund eine verbesserte Haftung, eine gewisse Elastizität und mechanische Stabilität gegen plastische Verformung des Substrats, so daß die erfindungsgemäß herstellbaren Verbundmaterialien auch nach Verformungen aufgrund der verminderten Rißbildung gegenüber bekannten, mit Barrierebeschichtungen beschichteten Substraten einen signifikant erhöhten BIF-Wert aufweisen (BIF="Barrier Improvement Factor", Barriereverbesserungsfaktor).

Daher sieht die Erfindung vor, das Verbundmaterial derart weiterzubilden, dass die organische Haftvermittlerschicht auf dem Substrat zumindest in den ersten Monolagen eine Lagenstruktur aufweist. Die sich an die organische Haftvermittlerschicht anschließenden Schichten weisen eine Säulenstruktur auf. Die beschichtete Oberfläche des Verbundmaterials ist vorteilhafterweise glatter, genauso glatt oder nur geringfügig rauher als die Oberfläche des unbeschichteten Substrats und/oder die Elastizität und mechanische Stabilität gegen plastische Verformung des Substrats sind für den Schichtverbund vorteilhafterweise größer als für anorganische Einzelschichten.

Da die erfindungsgemäße Beschichtung sehr glatt ist und eine spezifische Morphologie aufweist, wird eine gute Barrierewirkung schon bei geringen Schichtdicken realisiert. Die Erfindung bietet damit vorteilhafterweise die Möglichkeit zur Materialeinsparung und zur Realisierung schneller Beschichtungszeiten. Entsprechend liegt die erfindungsgemäße mittlere Schichtdicke einer organischen Schicht, insbesondere der organischen Haftvermittlerschicht, im Bereich von 1 nm bis 200 nm, vorzugsweise im Bereich von 5 nm bis 50 nm. Die mittlere Schichtdicke einer anorganischen Schicht liegt im Bereich von 5 nm bis 200 nm, die mittlere Schichtdicke einer anorganischen Schicht liegt im Bereich von 5 nm bis 200 nm, vorzugsweise im Bereich von 7,5 nm bis 50 nm.

Die Erfindung ermöglicht vorteilhafterweise zudem das Aufbringen besonders gleichmäßiger Schichten. Um die Gleichmäßigkeit zu kennzeichnen, wird die Uniformität definiert als das Verhältnis der minimalen Schichtdicke zur maximalen Schichtdicke, wobei Werte durch Messung über das gesamte Substrat ermittelt werden. Erfindungsgemäß liegt die Uniformität zumindest einer der auf dem Substrat abgeschiedenen Schichten bei einem Wert im Bereich von 0,1 bis 1, vorzugsweise im Bereich von 0,3 bis 1.

Mit der Erfindung können, wie vorstehend bereits angesprochen, vorteilhafterweise äußerst variable Zusammensetzungen der Schichten aus den aus dem Plasma abgeschiedenen Verbindungen realisiert werden. Die Schichtzusammensetzung einer organischen Schicht, insbesondere der organischen Haftvermittlerschicht, liegt dabei im Konzentrationsbereich von $Si_lO_xC_yN_z$ mit $1, 0 \leq x \leq 2, 8; 1,1 \leq y \leq 2, 8; 0 \leq z \leq 2, 8$. Die Schichtzusammensetzung einer anorganischen Schicht liegt im Konzentrationsbereich von $Si_lO_xC_yN_z$ mit $1,0 \leq x \leq 2,8; 0 \leq y \leq 0,29; 0 \leq z \leq 2,8$.

Mit einem häufigen Wechsel der Schichten steigt die Anzahl an Hindernissen an der zunehmenden Anzahl von Grenzflächen, damit wird die Barrierewirkung gesteigert. Die Erfindung sieht deswegen vor, dass die Wechselschicht des Verbundmaterials ein Multilayer ist, bei welchem auf einer anorganischen Schicht zumindest eine dritte Schicht, welche vorzugsweise organisch ist, aufgebracht wird. Der Multilayer kann auf der dritten Schicht eine vierte Schicht umfassen, welche vorzugsweise anorganisch ist und insbesondere eine Barriereschicht ist. Vorteilhafterweise kann der Multilayer zumindest sechs organische und/oder anorganische Wechselschichten im Wechsel umfassen.

Die Erfindung wird nachfolgend unter Bezugnahme auf die beigefügten Zeichnungen beschrieben. Gleiche oder ähnliche Bauteile werden in den Zeichnungen mit denselben Bezugszeichen bezeichnet.

Es zeigen:

Fig. 1    eine schematische Darstellung einer Anlage mit einer Vorrichtung zum Durchführen des erfindungsgemäßen Verfahrens,

Fig. 2    eine schematische Darstellung des Gaserzeugers,

Fig. 3    eine schematische Darstellung des erfindungsgemäßen Verbundmaterials,

Fig. 4    eine Darstellung einer PET-Flasche mit den verschiedenen Analysepositionen,

Fig. 5    Weißlichtinterferenz-Aufnahmen von unterschiedlichen Bereichen einer unbeschichteten PET-Flasche (A : Hals-, B : Wölbungs-, C : Bauch-, D : Bodenbereich),

Fig. 6    AFM-Aufnahmen von der unbeschichteten Innenseite einer PET-Flasche (Halsbereich),

Fig. 7    AFM-Aufnahmen von einem mit einer anorganischen Sperrschicht beschichteten Substrat (Substrat vergleichbar zu Fig. 6),

Fig. 8    eine rasterelektronenmikroskopische (SEM-) Aufnahme einer anorganischen Einzelschicht mit hoher Sperrwirkung,

Fig. 9    SEM-Aufnahmen einer Doppelschicht einer zunächst aufgebrachten organischen und einer anschließend aufgebrachten anorganischen Schicht,

Fig. 10    wie Fig. 9, jedoch mit deutlich glatterem Schichtverbund,

Fig. 11    wie Fig. 9, jedoch mit deutlich glatterem Schichtverbund,

Fig. 12    Querschliffaufnahme eines glatten Zweischichtverbundes aus organischer und anorganischer Schicht, wobei die erste Schicht im Lagenwachstum aufgewachsen ist.

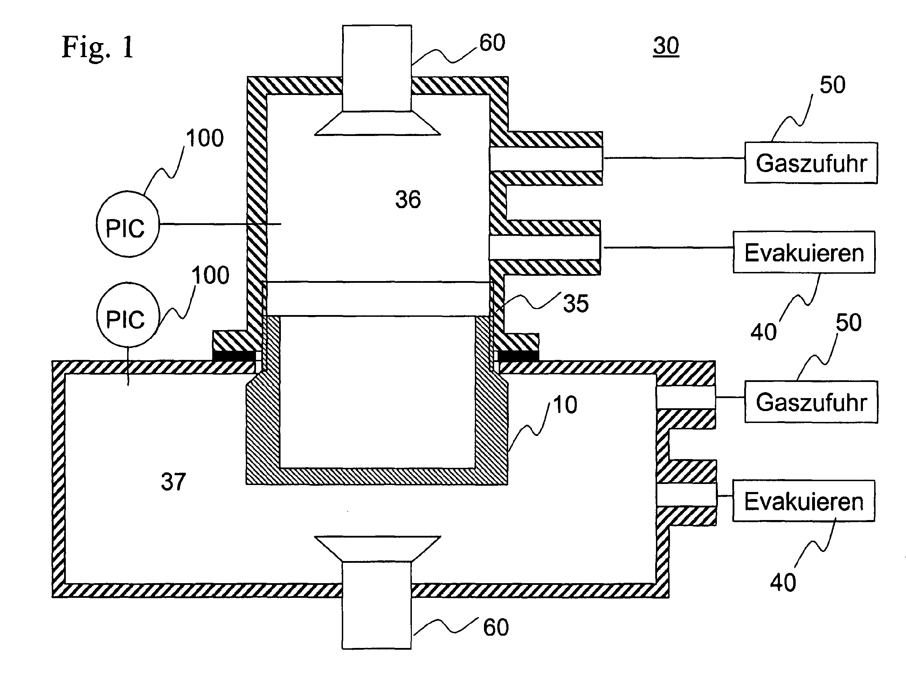

In Fig. 1 ist eine Beschichtungseinrichtung 30 der Vorrichtung 20 zum Aufbringen von Wechselschichten auf ein Substrat 10 dargestellt. Die Beschichtungseinrichtung 30 hat eine Halteeinrichtung 35, welche hier als Gewinde einer ersten Behandlungskammer mit einem Innenraum 36 dargestellt ist. In der Halteeinrichtung 35 kann das Substrat 10 eingespannt werden.

Die Beschichtungseinrichtung 30 umfasst des Weiteren eine Einrichtung 40 zum Evakuieren der Beschichtungseinrichtung 30 und eine Einrichtung 50 zum Zuführen eines Gasstroms in die Beschichtungseinrichtung 30. Des Weiteren ist zumindest eine Einrichtung 60 zum Erzeugen eines Plasmas in der zumindest einen Beschichtungseinrichtung 30 vorhanden. Die Einrichtung zum Erzeugen eines Plasmas kann in Form eines dielektrischen Fensters in der Beschichtungseinrichtung 30, durch das Mikrowellenenergie in die Beschichtungseinrichtung 30 eingekoppelt werden kann, ausgebildet sein. In Fig. 1 sind als eine mögliche Ausführungsform der Einrichtung zum Erzeugen eines Plasmas einfache Hornstrahler dargestellt.

Ist das Substrat 10, wie in Fig. 1 gezeigt, ein Hohlkörper, so sieht die Erfindung vor, diesen Hohlkörper in der Halteeinrichtung 35 so einzuspannen, dass der Innenraum des Substrats 10 sich an einen ersten Behandlungsraum 36 der Beschichtungseinrichtung 30 anschließt und die Außenseite des Substrats 10 in einen zweiten Behandlungsraum 37 hineinragt.

Jeder der beiden Behandlungsräume 36, 37 weist eine Gaszufuhr 50 sowie eine Einrichtung 40 zum Evakuieren des jeweiligen Behandlungsraumes auf. Des Weiteren sind für jeden Behandlungsraum zumindest eine Einrichtung 100 zum Steuern des Prozessdrucks vorgesehen.

Soll das Substrat 10 beschichtet werden, wird es in die Halteeinrichtung 35 eingespannt. Für eine Innenbeschichtung wird der erste Behandlungsraum 36, für eine Außenbeschichtung der zweite Behandlungsraum 37 evakuiert. Soll das Substrat 10 innen und außen beschichtet werden, werden beide Behandlungsräume evakuiert. Im Anschluss daran wird in den betreffenden Behandlungsraum bzw. beide Behandlungsräume die gewünschte Gasatmosphäre zugeführt. Ist der gewünschte Prozessdruck erreicht, wird das Plasma gezündet. Mit den vorher bestimmten Prozessparametern wird während der gewünschten Beschichtungszeit das Substrat 10 innen und/oder außen beschichtet.

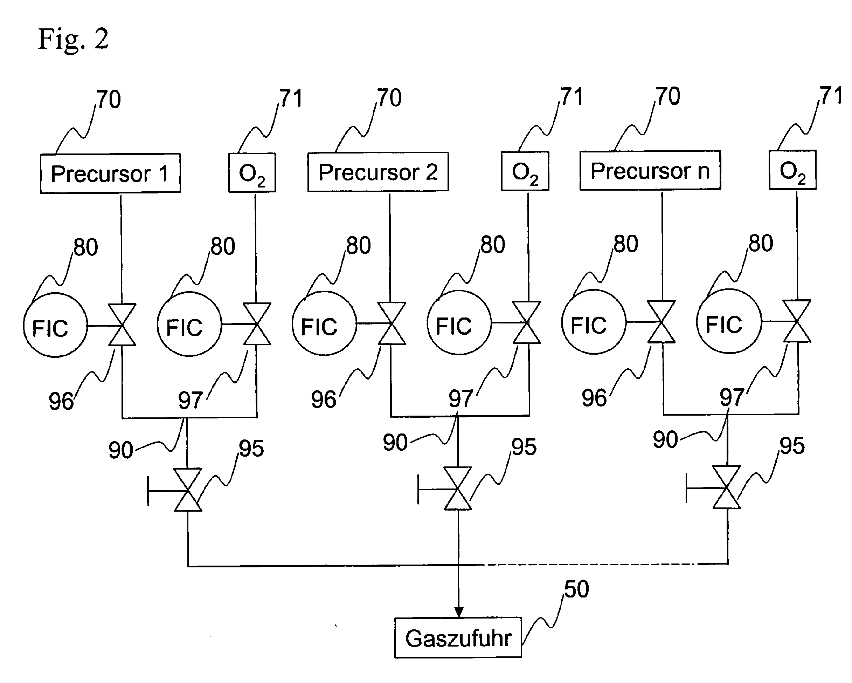

Während des Beschichtungsvorgangs kann die Gasatmosphäre verändert werden: in Fig. 2 ist eine mögliche Ausführungsform für den Gaserzeuger dargestellt. Der Gaserzeuger umfasst Vorratsbehälter 70 für das Precursorgas. Es können mehrere solche Vorratsbehälter 70 für das Precursorgas vorgesehen sein, in denen verschiedene Precursorgase oder jeweils dasselbe Precursorgas vorgelegt werden kann. Des Weiteren umfasst der Gaserzeuger Vorratsbehälter für das Reaktivgas 71. Zudem können Vorratsbehälter für das Trägergas 72 vorhanden sein (nicht dargestellt).

Die Vorratsbehälter (70, 71, 72) sind jeweils an einen Massenflussregler (Mass Flow Controller ,MFC) 80 angeschlossen. Über die Massenflussregler 80 können die Vorratsbehälter an zumindest einem Mischpunkt 90 in gewünschter Anzahl miteinander verbunden werden. Von dem zumindest einen Mischpunkt 90 kann eine Leitung zu der Beschichtungseinrichtung 30 führen, wobei die Leitung mit einem Ventil 95 verbindbar ist. Die Ventile 95 dienen dazu, von einem Prozess, beispielsweise dem Aufbringen einer Haftvermittlerschicht zu einem Prozess, beispielsweise dem Abscheiden einer anorganischen Barriereschicht, schnell umschalten zu können. Die Konzentration des Precursors kann z.B. über ein weiteres Ventil 96 angestellt werden. Desgleichen kann mit einem Ventil 97 die Konzentration des Reaktivgases gesteuert werden. Entsprechend kann die Konzentration des Trägergases mit einem Ventil 98 eingestellt werden (nicht dargestellt).

Das Umschalten von dem Beschichtungsvorgang einer Schicht zu dem Beschichtungsvorgang für die folgende Schicht kann dabei erfindungsgemäß auf unterschiedliche Weise durchgeführt werden: so können zunächst die Ventile für die erste Schicht geschlossen werden und nach einer kurzen Wartezeit, welche insbesondere weniger als eine Sekunde beträgt, die Ventile für die folgende Schicht geöffnet werden. Es ist auch möglich, die Ventile simultan ohne Wartezeit umzuschalten. Des Weiteren sieht die Erfindung vor, die Ventile mit einem sogenannten Überlapp zu schalten, so dass während einer Übergangszeit ein Gasgemisch aus den Prozessgasen für die eine und die folgende Schicht entsteht.

An die Ventile 95 können sich wiederum Leitungen anschließen, die miteinander verbunden werden können und so der Einrichtung für die Gaszufuhr 50 zugeleitet werden können.

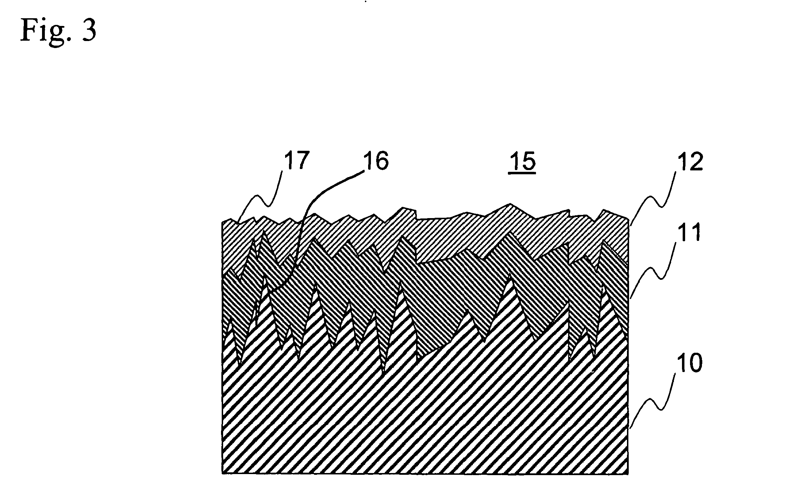

In Fig. 3 ist das erfindungsgemäße Verbundmaterial 15 aus einem Substrat 10 und einer Wechselschicht mit einer organischen Haftvermittlerschicht 11 und zumindest einer weiteren Schicht 12, welche anorganisch ist, schematisch dargestellt: insbesondere ist die Oberfläche 17 des Verbundmaterials 15 glatter als die Oberfläche 16 des Substrats 10.

Zur Charakterisierung der Schichten kann zum einen die Zunahme der Rauhigkeit des gesamten Verbunds aus einer organischen und einer darauffolgenden anorganischen Schicht im Vergleich zum unbeschichteten Substrat 10 herangezogen werden. Gegenüber dem unbeschichteten Substrat nimmt nach der Erfindung die Root Mean Square (RMS-) Rauhigkeit maximal um 50% der mittleren Schichtdicke der beiden Schichten 11, 12 zu, d.h. bei einer mittleren Schichtdicke von beispielsweise 50 nm nimmt die Rauhigkeit maximal um 25 nm zu. Durch Einfügen der organischen Schicht 11 nimmt die Rauhigkeit des Substrats 10 nicht weiter zu: im Vergleich zu einem mit einer anorganischen Barriereeinzelschicht versehenen Substrat zeigt ein Zweischichtverbund 15 aus einer organischen Schicht 11 und einer anorganischen Barriereschicht 12, die bei gleichen Parametern hergestellt wurden, maximal ebenfalls eine Zunahme der Rauhigkeit um 50 % der mittleren Schichtdicke der zweiten Schicht 12 gegenüber dem Substrat 10.

Zum anderen können die Schichten durch die Dichte an inneren Grenzflächen charakterisiert werden: quantitativ werden diese durch die Oberflächendichte an clusterartigen Strukturen beschrieben, die durch Grenzflächen voneinander getrennt sind. Das heißt, falls wenige Strukturen zu beobachten sind, liegt nach dem Modell nur eine geringe innere Grenzfläche vor, so dass eine deutlich bessere Barrierewirkung erzielt wird als im Fall vieler dichter clusterartiger Gebilde mit einer großen inneren Oberfläche. In dem erfindungsgemäßen günstigen Fall sind an der gesamten Oberfläche oder Teilbereichen keine oder nur wenige, d.h. maximal 200 auf einer Fläche von 1 $\mu m^2$ kontrastbildende runde Strukturen oder Partikel mit einer Strukturgröße bzw. einem Durchmesser von mehr als 50 nm vorhanden, die durch die Beschichtung erzeugt worden sind. Die Dichte an inneren Grenzflächen nimmt durch Einfügen der organischen Schicht 11 nicht oder nur geringfügig zu: im Vergleich zu einem mit einer anorganischen Barriereeinzelschicht versehenen Substrat nimmt bei einem Verbund 15 aus einer organischen Schicht 11 und einer zweiten anorganischen Barriereschicht 12, die bei gleichen Parametern hergestellt wurden, auf einer Fläche von 1 $\mu m^2$ die Zahl der kontrastbildenden runden Strukturen oder Partikel mit einer Größe bzw. einem Durchmesser von mehr als 50 nm um maximal 200 zu.

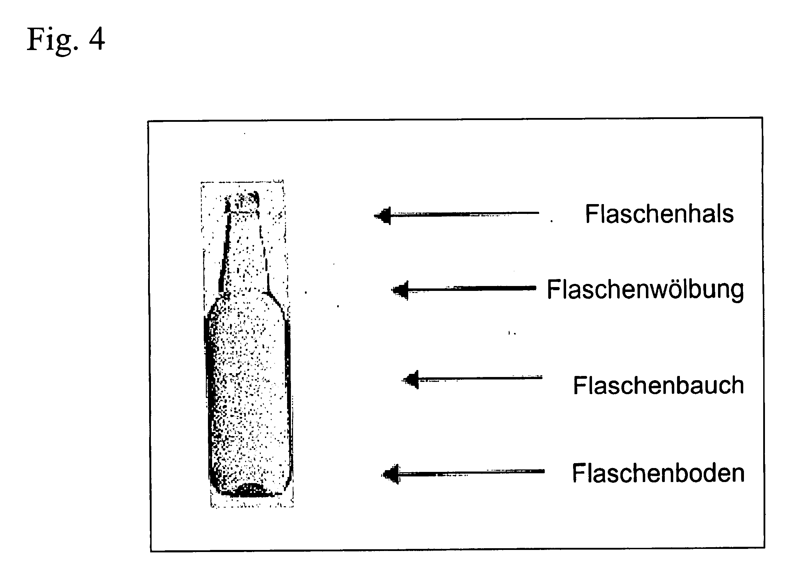

Zunächst wird die Grundrauhigkeit der Substrate betrachtet. In Fig. 4 ist als Beispiel eine PET-Flasche gezeigt, die in verschiedene Bereiche eingeteilt wird, nämlich den Flaschenhals, die Flaschenwölbung, den Flaschenbauch und den Flaschenboden.

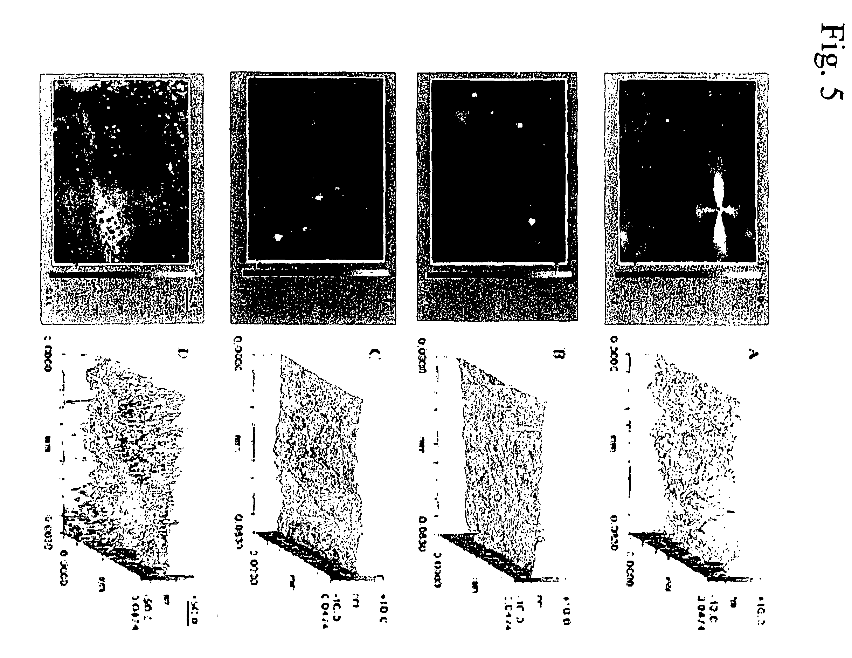

Fig. 5 zeigt Weißlicht-interferometrische Aufnahmen (WLI-Aufnahmen) von den unbeschichteten Substraten. Die Rauhigkeit des unbeschichteten Substrats ist je nach untersuchtem Probenbereich sehr unterschiedlich. In Fig. 5 erkennt man, dass die Flaschenwölbung (in Fig. 5 mit B bezeichnet) und der Flaschenbauch (C) weniger rauh sind als der Flaschenhals A, während der Bodenbereich D eine deutlich größere Rauhigkeit als die übrigen Flaschenbereiche aufweist. Daher ist es sinnvoll, nicht die absolute Oberflächenrauhigkeit, sondern die durch eine Beschichtung zusätzlich hinzugekommene bzw. ausgeglichene Rauhigkeit zu betrachten.

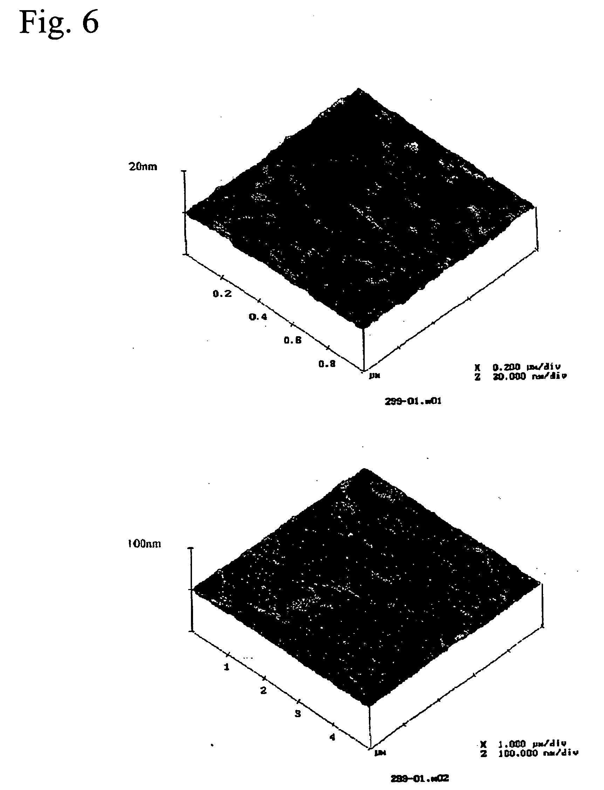

Fig. 6 zeigt Atomic Force Microscopy- (AFM-) Aufnahmen einer PET-Flasche, die im untersuchten Bereich eine sehr glatte Oberflächenmorphologie aufweist.

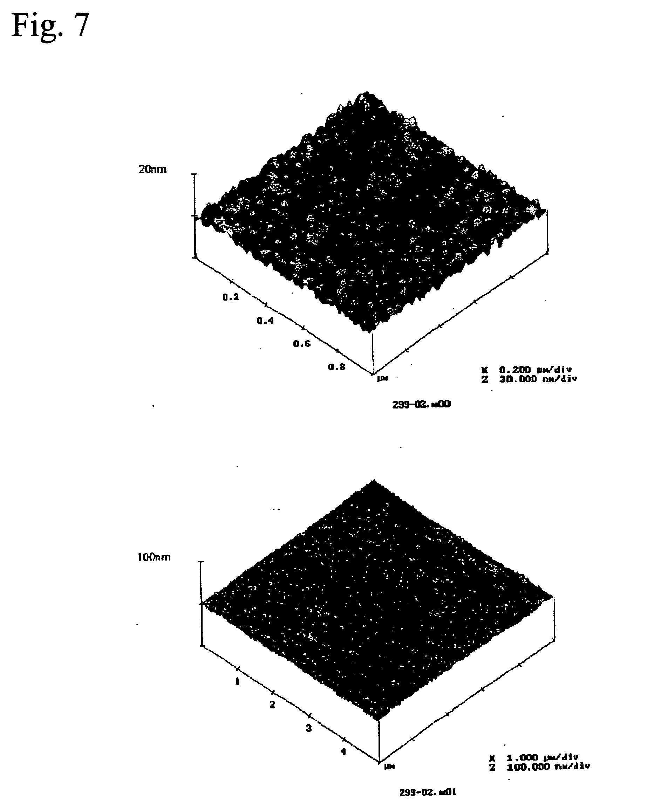

In Fig. 7 sind AFM-Aufnahmen von einem mit einer anorganischen Barriereschicht beschichteten Substrat gezeigt, wobei das Substrat vergleichbar mit dem aus Fig. 6 ist. Die Barriereschicht besitzt eine hohe Sperrwirkung. Die Rauhigkeit hat jedoch gegenüber dem Substrat nur geringfügig zugenommen. Es handelt sich daher um eine glatte Schicht. Die hohe Barrierewirkung ist dadurch verständlich, dass die Schicht geschlossen und sehr kompakt ist und keine starken topologischen Inhomogenitäten wie z.B. Poren vorhanden sind.

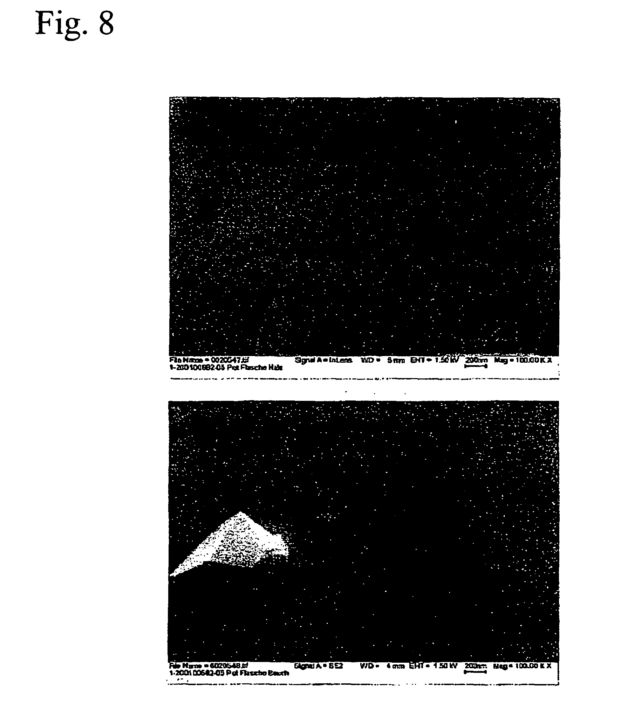

In Fig. 8 ist eine rasterelektronenmikroskopische (SEM-) Aufnahme einer anorganischen Einzelschicht mit hoher Barrierewirkung gezeigt: es liegt eine vollständige Bedeckung vor, und die Schicht ist sehr glatt. Es werden einzelne Unregelmäßigkeiten beobachtet; diese kommen jedoch durch das Substrat zustande. Die in Fig. 8 gezeigten Schichten sind jedoch mechanisch nur begrenzt belastbar. Bei starken Dehnungen kann es zur Rissbildung kommen.

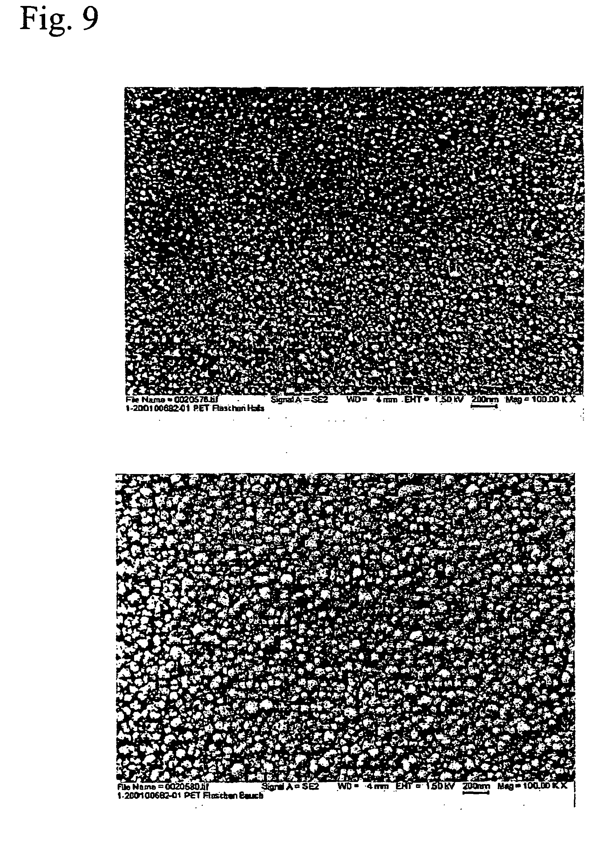

In Fig. 9 sind SEM-Aufnahmen von einer Doppelschicht aus einer zunächst aufgebrachten organischen und einer anschließend aufgebrachten anorganischen Schicht gezeigt. Dabei wurde die anorganische Schicht mit den gleichen Prozessparametern wie die Schicht, die in Fig. 8 dargestellt ist, hergestellt. Es kann daher Folgendes angenommen werden: die Prozessparameter für die organische Schicht sind so gewählt, dass diese Schicht bereits sehr rauh aufwächst. Auf diesem rauhen Substrat wächst die anorganische Schicht auf, wobei eine zusätzliche Aufrauhung zu erwarten ist. Dieser Schichtverbund besitzt nur eine geringfügige Barrierewirkung.

Die hohe Permeation ist verständlich, weil die Schichten deutlich rauher als die in Fig. 8 gezeigten sind. Es liegt eine hohe Dichte an inneren Grenzflächen vor, durch die Gasmoleküle sehr schnell diffundieren können.

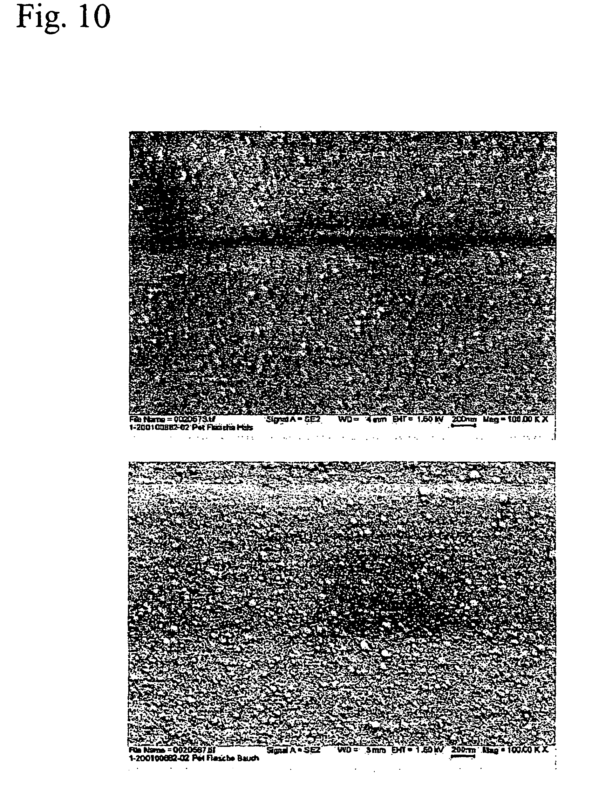

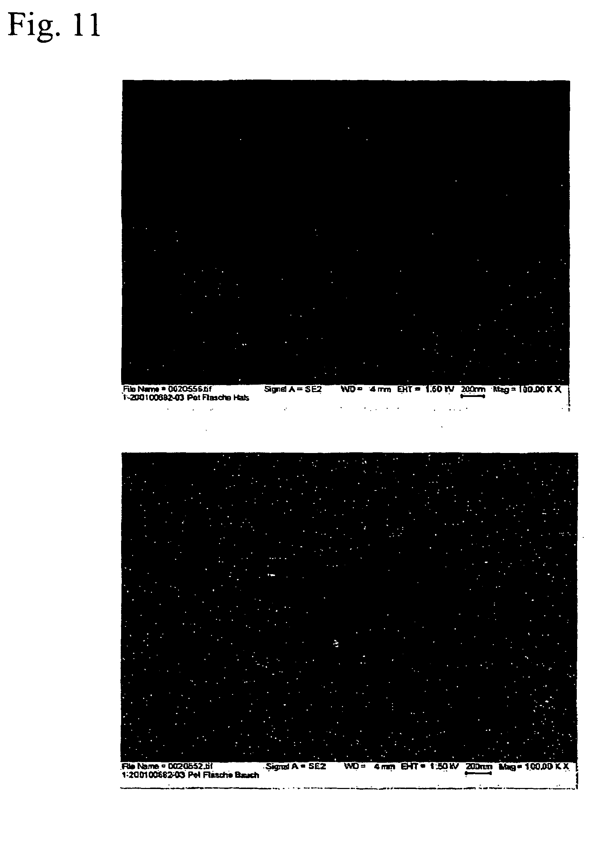

Die Figuren 10 und 11 dagegen zeigen einen deutlich glatteren Schichtverbund. Die Dichte an inneren Grenzflächen ist deutlich geringer als im Fall der in Fig. 9 gezeigten Schichten. Diese glatten Schichten weisen eine sehr hohe Sperrwirkung auf. Außerdem sind diese Schichtverbunde gegen lokale Dehnungen und plastische Verformungen belastbar, wie Ergebnisse aus folgendem Test verdeutlichen: die beschichteten Flaschen wurden mit 0,5 Litern karbonisierter Flüssigkeit mit einem $CO_2$-Anteil von 3,2 oder 4 % befüllt. Anschließend wurden die Flaschen mit einer Kunststoffkappe verschlossen. Dann wurden die befüllten verschlossenen Flaschen zunächst 24 Stunden bei Raumtemperatur und anschließend 24 Stunden bei 38˚C gelagert. Bei dem Testverfahren entsteht in der Flasche ein Innendruck von bis zu 5 bar, wodurch der Schichtsubstratverbund um lokal bis zu mehr als 4,5 % gedehnt wird. Nach diesen Dehnungsbelastungen wird immer noch eine hohe Sperrwirkung mit Verbesserungsfaktoren der Sauerstoffbarrierewirkung ($O_2$-BIF) von 27,4 bzw. 8,1 nachgewiesen.

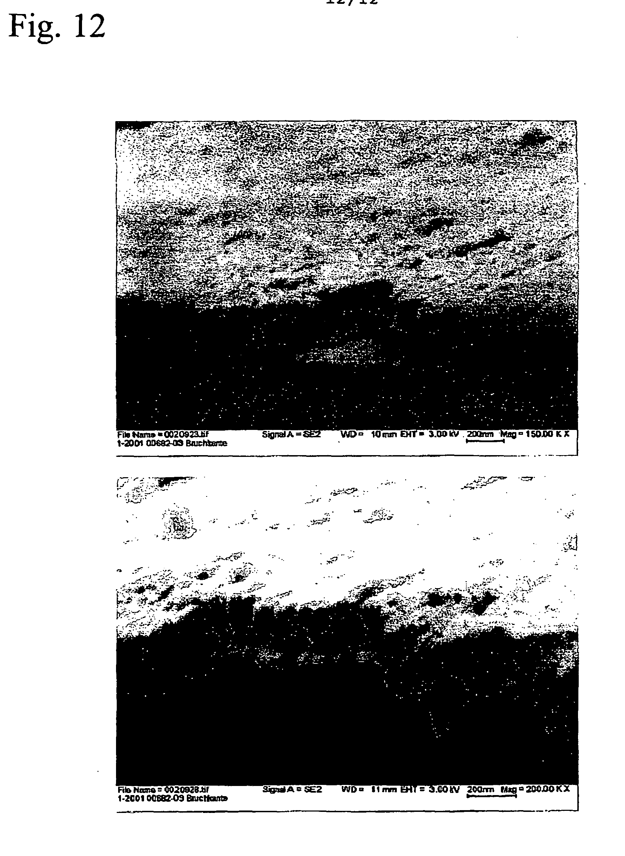

Fig. 12 zeigt eine Querschliffaufnahme eines glatten Zweischichtverbunds aus organischer und anorganischer Schicht. Zunächst wächst die Schicht im Lagenwachstum auf, ab einer gewissen Schichtdicke erfolgt ein Wechsel in einen Säulenwachstumsmodus. Es ist möglich, dass die lagenartige Schicht die organische und die säulenartige Schicht die Barrierenschicht ist. Es ist aber auch möglich, dass bei gleicher Beschichtung ein Wechsel der Wachstumsmode erfolgt, d.h. dass die Barriereschicht auch erst lagenartig aufwächst, leicht aufrauht und dann einen Übergang vom Lagenwachstum in ein Säulenwachstum erfolgt.

Ein derartiger Verbund ist im Vergleich zu einer reinen im Lagenwachstum abgeschiedenen Schicht mechanisch stabilisiert, da die Kräfte innerhalb der Grenzfläche zwischen den Säulen eine Stabilisierung gegenüber Dehnungsbelastungen bewirken.

Zusammenfassend ist daher für eine optimale Barriereschicht-Beschichtung zu fordern, dass die erste Schicht zumindest in den ersten Monolagen im Lagenwachstum aufwächst. Dann erfolgt ein Wechsel zum Säulen. Dabei muss diese Struktur sehr dicht sein, d.h. es dürfen keine unbedeckten Flächen und möglichst keine porösen Bereiche auftreten.

Weiterhin wäre bei Multilayern noch eine anschließende dritte organische Schicht, die wieder zu einer Glättung führt, und anschließend eine vierte Barriereschicht möglich. Dieser Aufbau kann entsprechend für eine fünfte, sechste, siebte usw. bis n-te Schicht fortgeführt werden.

Barriereeinzelschichten haben den Nachteil, dass sie sehr anorganisch, d.h. sehr spröde sind, wodurch sie unter Dehnungsbelastung anfällig gegen Rissbildung sind. Ferner haften sie nicht optimal auf dem Substrat, da nur geringe Bindungsenergien zwischen den SiO$_x$-Schicht und dem PET-Substrat vorliegen. Dieser Sachverhalt wird in der Tabelle 1 dargestellt: die mit Prozess 1 hergestellte anorganische Einzelschicht besitzt zwar eine an sich hoher Barrierewirkung, die allerdings nach einer Dehnungsbelastung im sogenannten Creep-Test mit 3,2 Vol-% CO$_2$, der vorstehend erläutert wurde, aufgrund von Rissbildung extrem reduziert wird.

In Tabelle 1 ist ein Vergleich zwischen den in den Experimenten variierten Prozessparametern und der Schichtmorphologie dargestellt. Aus den Daten ist folgender Zusammenhang ersichtlich. Wird die erste Schicht, wie in Prozess 2, bei einer HMDSN-Konzentration von 2 % oder, wie in Prozess 3, von 5 % abgeschieden, so besitzt der Verbund aus erster und zweiter Schicht eine rauhe Oberflächenmorphologie mit vielen inneren Grenzflächen. Die rauhe Oberflächenmorphologie liegt vor, obwohl die gemäß Prozess 1 abgeschiedene anorganische Einzelschicht, die bei gleichen Prozessparametern aufgebracht wurde wie Prozess 2 und Prozess 3, sehr glatt ist.

Bringt man dagegen, wie in Prozess 4, die erste Schicht bei einer höheren HMDSN-Konzentration von 35 %, oder wie in Prozess 5, von 40 % auf, so ist die Rauhigkeit des Verbundes aus erster und zweiter Schicht deutlich geringer, und es sind deutlich weniger innere Grenzflächen vorhanden. Zusätzlich ist die Dichte an clusterartigen Strukturen deutlich reduziert.

Nach der Modellvorstellung sind bei dem niedrigen Konzentrationsbereich von 2 bis 5 % für die erste organische Schicht die Abscheidebedingungen derart ungünstig, dass bereits diese sehr rauh aufwächst. Auf diesem Substrat wächst anschließend auch die zweite anorganische Schicht weiter, wobei die Struktur der Unterlage übernommen wird, und die Rauhigkeit und Dichte an Grenzflächen gleich bleibt oder sogar noch zunimmt. Dagegen wird bei höherer HMDSN-Konzentration der ersten Schicht ein deutlich verbessertes Lagenwachstum erreicht, das in ein Säulenwachstum übergehen kann.

Durch diese Wahl der Prozessparameter wird die Fragmentierung des Precursors derart beeinflusst, dass einzelne Fragmente in Form von Atomen, Molekülen, Ionen oder Radikalen mit den Molekülen des zu beschichteten Substrats reagieren und eine chemische Bindung (Chemisorption) eingehen. Diese Bindung ist gegenüber einer Physisorption bevorzugt. Durch die starke Bindung wird die Schichthaftung verbessert.

Ferner ist für die hohe HMDSN-Konzentration und gegebenen anderen Prozessparametern die Fragmentierung derart günstig, dass die erste organische Schicht sehr glatt aufwächst. Auf dieser ersten organischen Schicht kann dann die zweite anorganische Schicht deutlich glatter und mit deutlich weniger inneren Grenzflächen aufwachsen. Weil die erste organische Schicht deutlich weniger clusterartige Partikel aufweist, können nach Beschichtung mit der zweiten anorganischen Schicht deutlich weniger "pinholes" entstehen.

Die Fragmentierung des Precursors wird durch den Yasuda-Parameter bestimmt (Yasuda et al., J. Polym. Sci., Polym. Chem. Ed. 16 (1978) 743).

Tabelle 1: Zusammenhang zwischen der Prozessführung und den Eigenschaften der Beschichtung.

| Prozess | Figur | Dicke 1. Schicht | HMDSN-Konzentration 1. Schicht | Beschichtungszeit 1. Schicht | Pulsdauer 1. Schicht | Pulspause 1. Schicht | O$_2$-BIF nach Beschichtung | O$_2$-BIF nach Creep-Test (3,2%CO$_2$) |
|---|---|---|---|---|---|---|---|---|
| 1 | 8 | Keine 1. Schicht, nur 2. Anorganische Schicht | | | | | 24 | 1,5 |
| 2 | 9 | 100 nm | 5% | 12,8 s | 1,0 ms | 40 ms | 1,1 | 1,1 |
| 3 | Morphologie ähnlich wie bei Fig. 9 | 25 nm | 2% | 13s | 1,0 ms | 100 ms | 2,2 | 1,3 |
| 4 | 10 | 25 nm | 35% | 1,4 s | 1,0 ms | 50 ms | > 40 | > 20 |
| 5 | 11 und 12 | 25 nm | 40% | 4,3 s | 0,7 ms | 60 ms | > 40 | > 20 |

**EP 1 388 594 B1**

**Patentansprüche**

1. Verfahren zum Aufbringen von Schichten auf ein Substrat (10), wobei zum Beschichten ein Plasmaunterstütztes CVD-Verfahren eingesetzt wird, das insbesondere unter Verwendung von hochfrequenten elektromagnetischen Wellen, insbesondere Mikrowellen, in einer Gasatmosphäre, die zumindest einen siliziumhaltigen Precursor umfasst, erzeugt wird,

   wobei

   auf dem Substrat (10) vor dem Abscheiden zumindest einer weiteren, anorganischen Schicht mit einer Schichtzusammensetzung im Konzentrationsbereich von $Si_lO_xC_yN_z$ mit 1, $0 \leq x \leq 2, 8$; $0 \leq y \leq 0,29$; $0 \leq z \leq 2,8$, insbesondere einer Barriereschicht, zumindest eine organische Haftvermittlerschicht (11) abgeschieden wird, deren Schichtzusammensetzung im Konzentrationsbereich von $Si_lO_xC_yN_z$ mit $1,0 \leq x \leq 2,8$; $1,1 \leq y \leq 2,8$; $0 \leq z \leq 2,8$ liegt, die zumindest in den ersten Monolagen im Lagenwachstum aufwächst und wobei nach dem Aufbringen der organischen Haftvermittlerschicht (11) durch einen Wechsel der Gaskonzentration und/oder einen Wechsel des Prozessdrucks und/oder einen Wechsel des Precursorflusses und/oder durch einen Wechsel des Reaktivgasflusses kontinuierlich oder stufenförmig ein Wechsel vom Lagen- zum Säulenwachstum durchgeführt wird, **dadurch gekennzeichnet, dass** die Precursorkonzentration der Gasatmosphäre beim Abscheiden der organischen Schicht im Bereich von 10 bis 60 % und die Precursorkonzentration der Gasatmosphäre beim Abscheiden der anorganischen Schicht im Bereich von 0,5 bis 5 % liegt.

2. Verfahren nach Anspruch 1, wobei die Gasatmosphäre ein Trägergas und/oder ein Reaktivgas umfasst.

3. Verfahren nach Anspruch 2, **dadurch gekennzeichnet, dass** das Reaktivgas Sauerstoff umfasst.

4. Verfahren nach Anspruch 2 oder 3, **dadurch gekennzeichnet, dass** das Trägergas Stickstoff und/oder Helium und/oder Argon und/oder Xenon umfasst.

5. Verfahren nach einem der vorangegangenen Ansprüche, **dadurch gekennzeichnet, dass** die Precursorkonzentration beim Abscheiden der anorganischen Schicht im Bereich von 0,8 bis 3 % liegt.

6. Verfahren nach einem der vorangegangenen Ansprüche, **dadurch gekennzeichnet, dass** der Prozeßdruck beim Abscheiden der organischen Schicht im Bereich von 0,1 bis 1 mbar, bevorzugt im Bereich von 0,2 bis 0,6 mbar liegt, und/oder dass der Prozeßdruck beim Abscheiden einer anorganischen Schicht im Bereich von 0,1 bis 1 mbar, bevorzugt im Bereich von 0,2 bis 0,6 mbar liegt

7. Verfahren nach einem der vorangegangenen Ansprüche, **dadurch gekennzeichnet, dass** der Gesamtfluß beim Abscheiden einer organischen Schicht im Bereich von 10 bis 1000 sccm, bevorzugt im Bereich von 30 bis 500 sccm liegt, und/oder dass der Gesamtfluß beim Abscheiden der anorganischen Schicht im Bereich von 50 bis 1000 sccm, bevorzugt im Bereich von 100 bis 500 sccm liegt.

8. Verfahren nach einem der vorangegangenen Ansprüche, **dadurch gekennzeichnet, dass** ein gepulstes Plasma eingesetzt wird.

9. Verfahren nach Anspruch 9, wobei die Pulsdauer beim Abscheiden der organischen Schicht im Bereich von 0,05 bis 5 ms, bevorzugt im Bereich von 0,1 bis 1,0 ms liegt, und/oder dass die Pulsdauer beim Abscheiden der anorganischen Schicht im Bereich von 1 bis 50 ms, bevorzugt im Bereich von 2 bis 20 ms liegt.

10. Verfahren nach Anspruch 8 oder 9, wobei die Pulspause beim Abscheiden einer organischen Schicht im Bereich von 2 bis 100 ms, bevorzugt im Bereich von 5 bis 60 ms liegt, und/oder dass die Pulspause beim Abscheiden einer anorganischen Schicht im Bereich von 5 bis 200 ms, bevorzugt im Bereich von 10 bis 100 ms liegt.

11. Verfahren nach einem der Ansprüche 8 bis 10, **dadurch gekennzeichnet, dass** die Pulsleistung im Bereich von 100 bis 4500 W, bevorzugt im Bereich von 400 bis 2000 W liegt.

12. Verfahren nach einem der vorangegangenen Ansprüche, **dadurch gekennzeichnet, dass** die mittlere Leistungsdichte beim Abscheiden der organischen Schicht im Bereich von $1 \cdot 10^3$ J/kg bis $5 \cdot 10^7$ J/kg, bevorzugt im Bereich von $5 \cdot 10^5$ J/kg bis $5 \cdot 10^7$ J/kg liegt, und/oder dass die mittlere Leistungsdichte beim Abscheiden der anorganischen Schicht im Bereich von $4 \cdot 10^3$ J/kg bis $4 \cdot 10^9$ J/kg, bevorzugt im Bereich von $1 \cdot 10^6$ J/kg bis $2 \cdot 10^8$ J/kg liegt.

**13.** Verfahren nach einem der vorangegangenen Ansprüche, **dadurch gekennzeichnet, dass** die Beschichtungszeit beim Abscheiden der organischen Schicht im Bereich von 0,1 bis 20 s, bevorzugt im Bereich von 0,2 s bis 2 s liegt, und/oder dass die Beschichtungszeit beim Abscheiden der anorganischen Schicht im Bereich von 0,2 bis 60 s, bevorzugt im Bereich von 0,4 s bis 6 s liegt.

**14.** Verfahren nach einem der vorangegangenen Ansprüche, **dadurch gekennzeichnet, dass** das Rezipientenvolumen im Bereich von 10 ml bis 2000 ml, bevorzugt im Bereich von 30 ml bis 1000 ml liegt.

**15.** Verfahren nach einem der vorangegangenen Ansprüche, **dadurch gekennzeichnet, dass** der zumindest eine siliziumhaltige Precursor aus der Gruppe ausgewählt wird, welche HMDSN, HMDSO, TMDSO, Silan in $N_2$, TEOS Siliziumchlorid umfasst.

**16.** Verfahren nach einem der vorangegangenen Ansprüche, **dadurch gekennzeichnet, dass** für die einzelnen Schichten verschiedene Precursor eingesetzt werden oder für die einzelnen Schichten der gleiche Precursor eingesetzt wird.

**17.** Verfahren nach einem der vorangegangenen Ansprüche, **dadurch gekennzeichnet, dass** die Precursor und/oder die Reaktivgase für die einzelnen Schichten separat zugeführt werden.

**18.** Verfahren nach einem der vorangegangenen Ansprüche, **dadurch gekennzeichnet, dass** für die einzelnen Schichten verschiedene Reaktivgase und/oder Trägergase eingesetzt werden oder für die einzelnen Schichten das gleiche Reaktivgas und/oder Trägergas eingesetzt wird.

**19.** Verfahren nach einem der vorangegangenen Ansprüche, **dadurch gekennzeichnet, dass** auf dem Substrat (10) ein Verbund (15) aus Haftvermittlerschicht (11) und zumindest einer weiteren Schicht (12) hergestellt wird, dessen Oberfläche (17) glatter als die Oberfläche (16) des Substrats (10) ist.

**20.** Verfahren nach einem der vorangegangenen Ansprüche, **dadurch gekennzeichnet, dass** auf dem Substrat (10) ein Verbund (15) aus organischer Haftvermittlerschicht (11) und der zumindest einen weiteren, anorganischen Schicht (12) hergestellt wird, welcher nach einer mechanischen Belastung mit lokalen Dehnungen von mehr als 3%, vorzugsweise mehr als 4%, und/oder plastischen Verformungen des Substrats und damit verbundenen Dehnungen der Schichten um mehr als 3%, vorzugsweise mehr als 4% eine Barriereverbesserung gegenüber dem unbeschichteten Substrat mit einem Barriereverbesserungsfaktor größer als 1,5, vorzugsweise größer als 2,0 aufweist.

**21.** Verbundmaterial (15) aus einem Substrat (10) und einer Wechselschicht, welche eine organische Haftvermittlerschicht (11) und zumindest eine weitere anorganische Schicht (12) umfasst, wobei die organische Haftvermittlerschicht (11) auf dem Substrat (10) zumindest in den ersten Monolagen eine Lagenstruktur aufweist,
**dadurch gekennzeichnet, dass** auf einer Fläche von 1 $\mu m^2$ maximal zweihundert kontrastgebende Strukturen mit einer Strukturgröße von mehr als 50 Nanometern durch Beschichten erzeugt sind, wobei die sich an die organische Haftvermittlerschicht (11) anschließende anorganische Schicht eine Säulenstruktur aufweist, und
die Schichtzusammensetzung der organischen Haftvermittlerschicht (11) im Konzentrationsbereich von $Si_lO_xC_yN_z$ mit $1,0 \leq x \leq 2,8$; $1,1 \leq y \leq 2,8$; $0 \ z \leq 2,8$ liegt und die Schichtzusammensetzung der anorganischen Schicht im Konzentrationsbereich von $Si_lO_xC_yN_z$ mit $1,0 \leq x \leq 2, 8$; $0 \leq y \leq 0,29$; $0 \leq z \leq 2,8$ liegt.

**22.** Verbundmaterial (15) nach Anspruch 21, **dadurch gekennzeichnet, dass** die Oberfläche (17) des Verbundmaterials (15) glatter als die Oberfläche (16) des Substrats (10) ist.

**23.** Verbundmaterial (15) nach einem der Ansprüche 21 oder 22, **dadurch gekennzeichnet, dass** das Verbundmaterial (15) nach einer mechanischen Belastung mit lokalen Dehnungen von mehr als 3%, vorzugsweise mehr als 4%, und/oder plastischen Verformungen des Substrats und damit verbundenen Dehnungen der Schichten um mehr als 3%, vorzugsweise mehr als 4% eine Barriereverbesserung gegenüber dem unbeschichteten Substrat mit einem Barriereverbesserungsfaktor größer als 1,5, vorzugsweise größer als 2,0 aufweist.

**24.** Verbundmaterial (15) nach einem der Ansprüche 21 bis 23, **dadurch gekennzeichnet, dass** die mittlere Schichtdicke der organischen Haftvermittlerschicht (11), im Bereich von 1 nm bis 200 nm, vorzugsweise im Bereich von 5 nm bis 50 nm liegt und/oder dass die mittlere Schichtdicke einer anorganischen Schicht im Bereich von 5 nm bis 200 nm, vorzugsweise im Bereich von 7,5 nm bis 50 nm liegt.

**25.** Verbundmaterial (15) nach einem der Ansprüche 21 bis 24, **dadurch gekennzeichnet, dass** die Uniformität zumindest einer der Schichten (11, 12) im Bereich von 0,1 bis 1, vorzugsweise im Bereich von 0,3 bis 1 liegt.

**26.** Verbundmaterial (15) nach einem der Ansprüche 21 bis 25, **dadurch gekennzeichnet, dass** die Wechselschicht ein Multilayer ist, bei welchem auf einer anorganischen Schicht zumindest eine dritte Schicht, welche vorzugsweise organisch ist, aufgebracht ist.

**27.** Verbundmaterial (15) nach Anspruch 26, **dadurch gekennzeichnet, dass** der Multilayer auf der dritten Schicht eine vierte Schicht umfasst, welche vorzugsweise anorganisch ist, und insbesondere eine Barriereschicht ist.

**28.** Verbundmaterial (15) nach Anspruch 26 oder 27, **dadurch gekennzeichnet, dass** der Multilayer zumindest sechs organische und/oder anorganische Schichten im Wechsel umfasst.

**Claims**

**1.** Method for superimposing layers onto a substrate (10), wherein a plasma-assisted CVD method is used for coating purposes and is produced in particular using high-frequency electromagnetic waves, in particular microwaves, in a gas atmosphere which includes at least one silicon-containing precursor, wherein prior to depositing at least one further inorganic layer having a layer composition in the concentration range of $Si_lO_xC_yN_z$ with $1.0 \leq x \leq 2.8$; $0 \leq y \leq 0.29$; $0 \leq z \leq 2.8$, in particular a barrier layer, at least one organic adhesive layer (11) is deposited onto the substrate (10) and has a layer composition in the concentration range of $Si_lO_xC_yN_z$ with $1.0 \leq x \leq 2.8$; $1.1 \leq y \leq 2.8$; $0 \leq z \leq 2.8$ which increases in layer growth at least in the first monolayers, and wherein after superimposing the organic adhesive layer (11) a change from layer growth to column growth is effected continuously or in stages by changing the gas concentration and/or changing the process pressure and/or changing the precursor flow and/or changing the reactive gas flow, **characterised in that** the precursor concentration of the gas atmosphere when depositing the organic layer is in the range of 10 to 60% and the precursor concentration of the gas atmosphere when depositing the inorganic layer is in the range of 0.5 to 5%.

**2.** Method as claimed in Claim 1, wherein the gas atmosphere includes a carrier gas and/or a reactive gas.

**3.** Method as claimed in Claim 2, **characterised in that** the reactive gas includes oxygen.

**4.** Method as claimed in Claim 2 or 3, **characterised in that** the carrier gas includes nitrogen and/or helium and/or argon and/or xenon.

**5.** Method as claimed in any one of the preceding Claims, **characterised in that** the precursor concentration when depositing the inorganic layer is in the range of 0.8 to 3%.

**6.** Method as claimed in any one of the preceding Claims, **characterised in that** the process pressure when depositing the organic layer is in the range of 0.1 to 1 mbar, preferably in the range of 0.2 to 0.6 mbar and/or **in that** the process pressure when depositing an inorganic layer is in the range of 0.1 to 1 mbar, preferably in the range of 0.2 to 0.6 mbar.

**7.** Method as claimed in any one of the preceding Claims, **characterised in that** the overall flow when depositing an organic layer is in the range of 10 to 1000 sccm, preferably in the range of 30 to 500 sccm and/or **in that** the overall flow when depositing the inorganic layer is in the range of 50 to 1000 sccm, preferably in the range of 100 to 500 sccm.

**8.** Method as claimed in any one of the preceding Claims, **characterised in that** a pulsed plasma is used.

**9.** Method as claimed in Claim 9 [*sic*], wherein the pulse duration when depositing the organic layer is in the range of 0.05 to 5 ms, preferably in the range of 0.1 to 1.0 ms and/or in that the pulse duration when depositing the inorganic layer is in the range of 1 to 50 ms, preferably in the range of 2 to 20 ms.

**10.** Method as claimed in Claim 8 or 9, wherein the pulse interval when depositing an organic layer is in the range of 2 to 100 ms, preferably in the range of 5 to 60 ms and/or in that the pulse interval when depositing an inorganic layer is in the range of 5 to 200 ms, preferably in the range of 10 to 100 ms.

11. Method as claimed in any one of Claims 8 to 10, **characterised in that** the pulse power is in the range of 100 to 4500 W, preferably in the range of 400 to 2000 W.

12. Method as claimed in any one of the preceding Claims, **characterised in that** the power density when depositing the organic layer is in the range of $1 \cdot 10^3$ J/kg to $5 \cdot 10^7$ J/kg, preferably in the range of $5 \cdot 10^5$ J/kg to $5 \cdot 10^7$ J/kg and/or **in that** the power density when depositing the inorganic layer is in the range of $4 \cdot 10^3$ J/kg to $4 \cdot 10^9$ J/kg, preferably in the range of $1 \cdot 10^5$ J/kg to $2 \cdot 10^8$ J/kg.

13. Method as claimed in any one of the preceding Claims, **characterised in that** the coating time when depositing the organic layer is in the range of 0.1 to 20 s, preferably in the range of 0.2 s to 2 s and/or **in that** the coating time when depositing the inorganic layer is in the range of 0.2 to 60 s, preferably in the range of 0.4 s to 6 s.

14. Method as claimed in any one of the preceding Claims, **characterised in that** the recipient volume is in the range of 10 ml to 2000 ml, preferably in the range of 30 ml to 1000 ml.

15. Method as claimed in any one of the preceding Claims, **characterised in that** the at least one silicon-containing precursor is selected from the group including HMDSN, HMDSO, TMDSO, silane in $N_2$, TEOS, silicon chloride.

16. Method as claimed in any one of the preceding Claims, **characterised in that** different precursors are used for the individual layers or the same precursor is used for the individual layers.

17. Method as claimed in any one of the preceding Claims, **characterised in that** the precursors and/or the reactive gases are supplied separately for the individual layers.

18. Method as claimed in any one of the preceding Claims, **characterised in that** different reactive gases and/or carrier gases are used for the individual layers or the same reactive gas and/or carrier gas is used for the individual layers.

19. Method as claimed in any one of the preceding Claims, **characterised in that** a composite (15) consisting of an adhesive layer (11) and at least one further layer (12) is produced on the substrate (10), the surface (17) of the composite being smoother than the surface (16) of the substrate (10).

20. Method as claimed in any one of the preceding Claims, **characterised in that** a composite (15) consisting of an organic adhesive layer (11) and the at least one further inorganic layer (12) is produced on the substrate (10) and has a barrier improvement with respect to the uncoated substrate having a barrier improvement factor greater than 1.5, preferably greater than 2.0, after mechanical loading with local strains of more than 3%, preferably more than 4%, and/or plastic deformations of the substrate and associated strains of the layers by more than 3%, preferably more than 4%.

21. Composite material (15) consisting of a substrate (10) and an alternating layer which includes an organic adhesive layer (11) and at least one further inorganic layer (12), wherein the organic adhesive layer (11) has a layer structure on the substrate (10) at least in the first monolayers,
**characterised in that** on a surface of 1 $\mu m^2$ a maximum of two hundred contrast structures having a structure size of more than 50 nanometres are produced by coating, wherein the inorganic layer adjoining the organic adhesive layer (11) comprises a column structure, and
the layer composition of the organic adhesive layer (11) is in the concentration range of $Si_1O_xC_yN_z$ with $1.0 \leq x \leq 2.8$; $1.1 \leq y \leq 2.8$; $0 \leq z \leq 2.8$, and the layer composition of the inorganic layer is in the concentration range of $Si_1O_xC_yN_z$ with $1.0 \leq x \leq 2.8$; $0 \leq y \leq 0.29$; $0 \leq z \leq 2.8$.

22. Composite material (15) as claimed in Claim 21, **characterised in that** the surface (17) of the composite material (15) is smoother than the surface (16) of the substrate (10).

23. Composite material (15) as claimed in any one of Claims 21 or 22, **characterised in that** the composite material (15) has a barrier improvement with respect to the uncoated substrate having a barrier improvement factor greater than 1.5, preferably greater than 2.0, after mechanical loading with local strains of more than 3%, preferably more than 4%, and/or plastic deformations of the substrate and associated strains of the layers by more than 3%, preferably more than 4%.

24. Composite material (15) as claimed in any one of Claims 21 to 23, **characterised in that** the average layer thickness of the organic adhesive layer (11) is in the range of 1 nm to 200 nm, preferably in the range of 5 nm to 50 nm and/or **in that** the average layer thickness of an inorganic layer is in the range of 5 nm to 200 nm, preferably in the range of 7.5 nm to 50 nm.

25. Composite material (15) as claimed in any one of Claims 21 to 24, **characterised in that** the uniformity of at least one of the layers (11, 12) is in the range of 0.1 to 1, preferably in the range of 0.3 to 1.

26. Composite material (15) as claimed in any one of Claims 21 to 25, **characterised in that** the alternating layer is a multilayer, in which at least one third layer, which is preferably organic, is superimposed onto an inorganic layer.

27. Composite material (15) as claimed in Claim 26, **characterised in that** the multilayer includes a fourth layer on the third layer, which fourth layer is preferably inorganic and is in particular a barrier layer.

28. Composite material (15) as claimed in Claim 26 or 27, **characterised in that** the multilayer includes at least six alternating organic and/or inorganic layers.


**Revendications**

1. Procédé d'application de couches sur un substrat (10), impliquant pour la formation des couches l'utilisation d'un processus de dépôt chimique en phase vapeur, assisté par plasma, généré en particulier par l'emploi d'ondes électromagnétiques à haute fréquence, particulièrement de micro-ondes, dans une atmosphère gazeuse qui comprend au moins un précurseur contenant du silicium,
procédé dans lequel est déposée sur le substrat (10), préalablement au dépôt d'au moins une autre couche inorganique dont la composition a comme plages de concentrations de $Si_1O_xC_yN_z$ des valeurs $1,0 \leq x \leq 2,8$ ; $0 \leq y \leq 0,29$ ; $0 \leq z \leq 2,8$, en particulier d'une couche d'arrêt, au moins une couche organique d'adhérence (11) dont la composition a comme plages de concentrations de $Si_1O_xC_yN_z$ des valeurs $1,0 \leq x \leq 2,8$ ; $1,1 \leq y \leq 2,8$ ; $0 \leq z \leq 2,8$, qui s'accroît au moins dans les premières monocouches dans la croissance en couches et dans lequel, après l'application de la couche organique d'adhérence (11), un passage de la croissance en couches à la croissance en colonnes est effectué en continu ou par étapes par un changement de la concentration en gaz et/ou par un changement de la pression de travail et/ou par un changement du flux de précurseur et/ou par un changement du flux de gaz réactif, **caractérisé en ce que** la concentration en précurseur de l'atmosphère gazeuse lors du dépôt de la couche organique se situe dans la plage de 10 à 60 % et la concentration en précurseur de l'atmosphère gazeuse lors du dépôt de la couche inorganique se situe dans la plage de 0,5 à 5 %.

2. Procédé suivant la revendication 1, dans lequel l'atmosphère gazeuse comprend un gaz porteur et/ou un gaz réactif.

3. Procédé suivant la revendication 2, **caractérisé en ce que** le gaz réactif comprend de l'oxygène.

4. Procédé suivant la revendication 2 ou 3,
**caractérisé en ce que** le gaz porteur comprend de l'azote et/ou de l'hélium et/ou de l'argon et/ou du xénon.

5. Procédé suivant l'une des revendications précédentes, **caractérisé en ce que** la concentration en précurseur lors du dépôt de la couche inorganique se situe dans la plage de 0,8 à 3 %.

6. Procédé suivant l'une des revendications précédentes, **caractérisé en ce que** la pression de travail lors du dépôt de la couche organique se situe dans la plage de 0,1 à 1 mbar, avantageusement dans la plage de 0,2 à 0,6 mbar et/ou **en ce que** la pression de travail lors du dépôt d'une couche inorganique se situe dans la plage de 0,1 à 1 mbar, avantageusement dans la plage de 0,2 à 0,6 mbar.

7. Procédé suivant l'une des revendications précédentes, **caractérisé en ce que** le volume total écoulé lors du dépôt d'une couche organique se situe dans la plage de 10 à 1000 $cm^3$ mesurés dans des conditions normales, avantageusement dans la plage de 30 à 500 $cm^3$ mesurés dans des conditions normales, et/ou **en ce que** le volume total écoulé lors du dépôt d'une couche inorganique se situe dans la plage de 50 à 1000 $cm^3$ mesurés dans des conditions normales, avantageusement dans la plage de 100 à 500 $cm^3$ mesurés dans des conditions normales.

8. Procédé suivant l'une des revendications précédentes, **caractérisé en ce qu'**un plasma pulsé est utilisé.

**9.** Procédé suivant l'une des revendications précédentes, **caractérisé en ce que** la durée des impulsions lors du dépôt de la phase organique se situe dans la plage de 0,05 à 5 ms, avantageusement dans la plage de 0,1 à 1,0 ms, et/ou la durée des impulsions lors du dépôt de la phase inorganique se situe dans la plage de 1 à 50 ms, avantageusement dans la plage de 2 à 20 ms.

**10.** Procédé suivant la revendication 8 ou 9,
**caractérisé en ce que** l'intervalle entre les impulsions lors du dépôt de la couche organique se situe dans la plage de 2 à 100 ms, avantageusement dans la plage de 5 à 60 ms, et/ou **en ce que** l'intervalle entre les impulsions lors du dépôt d'une couche inorganique se situe dans la plage de 5 à 200 ms, avantageusement dans la plage de 10 à 100 ms.

**11.** Procédé suivant l'une des revendicatioins 8 à 10, **caractérisé en ce que** la puissance des impulsions se situe dans une plage de 100 à 4500 W, avantageusement dans la plage de 400 à 2000 W.

**12.** Procédé suivant l'une des revendications précédentes, **caractérisé en ce que** l'énergie massique moyenne lors du dépôt de la couche organique se situe dans la plage de $1 \cdot 10^3$ J/kg à $5 \cdot 10^7$ J/kg, avantageusement dans la plage de $5 \cdot 10^5$ J/kg à $5 \cdot 10^7$ J/kg, et/ou **en ce que** l'énergie massique moyenne lors du dépôt de la couche inorganique se situe dans la plage de $4 \cdot 10^3$ J/kg à $4 \cdot 10^9$ J/kg, avantageusement dans la plage de $1 \cdot 10^6$ J/kg à $2 \cdot 10^9$ J/kg.

**13.** Procédé suivant l'une des revendications précédentes, **caractérisé en ce que** le temps de revêtement lors du dépôt de la couche organique se situe dans une plage de 0,1 s à 20 s, avantageusement dans la plage de 0,2 s à 2 s, et/ou **en ce que** le temps de revêtement lors du dépôt de la couche inorganique se situe dans une plage de 0,2 s à 60 s, avantageusement dans la plage de 0,4 s à 6 s.

**14.** Procédé suivant l'une des revendications précédentes, **caractérisé en ce que** la capacité du récipient se situe dans une plage de 10 ml à 2000 ml, avantageusement dans la plage de 30 ml à 1000 ml.

**15.** Procédé suivant l'une des revendications précédentes, **caractérisé en ce que** le ou les précurseur(s) contenant du silicium est (sont) choisi(s) dans le groupe formé de HMDSN, HMDSO, TMDSO, silane dans $N_2$, TEOS, chlorure de silicium.

**16.** Procédé suivant l'une des revendications précédentes, **caractérisé en ce qu'**un précurseur différent est utilisé pour les couches individuelles ou bien le même précurseur est utilisé pour les couches individuelles.

**17.** Procédé suivant l'une des revendications précédentes, **caractérisé en ce que** le précurseur et/ou les gaz réactifs pour les couches individuelles sont amenés séparément.

**18.** Procédé suivant l'une des revendications précédentes, **caractérisé en ce que** des gaz réactifs différents et/ou des gaz porteurs différents sont utilisés pour les couches individuelles ou bien le même gaz réactif et/ou le même gaz porteur est ou sont utilisé (s) pour les couches individuelles.

**19.** Procédé suivant l'une des revendications précédentes, **caractérisé en ce qu'**un composite (15) formé de la couche d'adhérence (11) et d'au moins une autre couche (12) et dont la surface (17) est plus lisse que la surface (16) du substrat (10) est établi sur le substrat (10).

**20.** Procédé suivant l'une des revendications précédentes, **caractérisé en ce qu'**il est établi sur le substrat (10) un composite (15), formé d'une couche organique d'adhérence (11) et d'au moins une autre couche inorganique (12), lequel présente après une sollicitation mécanique avec des allongements locaux de plus de 3 %, avantageusement de plus de 4 %, et/ou avec des déformations plastiques du substrat et des allongements consécutifs des couches de plus de 3 %, avantageusement de plus de 4 %, une amélioration de l'effet de barrière, par rapport au substrat sans revêtement, avec un facteur d'amélioration de cet effet supérieur à 1,5, avantageusement supérieur à 2,0.

**21.** Matériau composite (15) constitué d'un substrat (10) et d'une couche alternant qui comprend une couche organique d'adhérence (11) et au moins une autre couche organique (12), la couche organique d'adhérence (11) sur le substrat (10) présentant une structure stratifiée au moins dans les premières monocouches, **caractérisé en qu'**au maximum deux cents structures formant contraste d'une grandeur structurale de plus de 50 nanomètres, sur une surface de $1\ \mu m^2$, sont produites par formation de couches, la couche inorganique adjacente à la couche organique d'adhérence (11) présentant une structure en colonnes, et la composition de la couche organique d'adhérence (11) ayant comme plages de concentrations de $Si_lO_xC_yN_z$ des valeurs 1, $0 \leq x \leq 2,8$ ; $0 \leq y \leq 0,29$ ; $0 \leq z \leq 2,8$ et la composition de la couche inorganique ayant comme plages de concentrations de $Si_lO_xC_yN_z$ des valeurs $1,0 \leq x \leq 2,8$ ; $1,1 \leq y \leq 2,8$ ; $0 \leq z \leq 2,8$.

22. Matériau composite (15) suivant la revendication 21, **caractérisé en ce que** la surface (17) du matériau composite (15) est plus lisse que la surface (16) du substrat (10).

23. Matériau composite (15) suivant l'une des revendications 21 et 22, **caractérisé en ce que** le matériau composite (15) présente après une sollicitation mécanique avec des allongements locaux de plus de 3 %, avantageusement de plus de 4 %, et/ou avec des déformations plastiques du substrat et des allongements consécutifs des couches de plus de 3 %, avantageusement de plus de 4 %, une amélioration de l'effet de barrière, par rapport au substrat sans revêtement, avec un facteur d'amélioration de cet effet supérieur à 1,5, avantageusement supérieur à 2,0.

24. Matériau composite (15) suivant l'une des revendications 21 à 23, **caractérisé en ce que** l'épaisseur moyenne de la couche organique d'adhérence (11) se situe dans une plage de 5 nm à 50 nm et/ou **en ce que** l'épaisseur moyenne d'une couche inorganique se situe dans une plage de 5 nm à 200 nm, avantageusement dans la plage de 7,5 nm à 50 nm.

25. Matériau composite (15) suivant l'une des revendications 21 à 24, **caractérisé en ce que** l'uniformité d'au moins l'une des couches (11,12) se situe dans une plage de 0,1 à 1, avantageusement dans la plage de 0,3 à 1.

26. Matériau composite (15) suivant l'une des revendications 21 à 25, **caractérisé en ce que** la couche alternante est une multicouche pour laquelle au moins une troisième couche qui est avantageusement de nature organique est appliquée sur une couche inorganique.

27. Matériau composite (15) suivant la revendication 26, **caractérisé en ce que** la multicouche comprend sur la troisième couche une quatrième couche qui est avantageusement de nature inorganique, et qui est en particulier une couche d'arrêt.

28. Matériau composite (15) suivant la revendication 26 ou 27, **caractérisé en ce que** la multicouche comprend au moins six couches organiques et/ou couches inorganiques en alternance.

Fig. 1

60    _30_

50

100

Gaszufuhr

PIC

36

Evakuieren

100

40    50

PIC

35

10

Gaszufuhr

37

Evakuieren

60    40

EP 1 388 594 B1

Fig. 2

EP 1 388 594 B1

Fig. 3

Fig. 4

# Fig. 5

# Fig. 6

20nm

0.2

0.4

0.6

0.8

µm

X 0.200 µm/div
Z 20.000 nm/div

299-01.w01

100nm

1

2

3

4

µm

X 1.000 µm/div
Z 100.000 nm/div

299-01.w02

## Fig. 7

Fig. 8

Fig. 9

# Fig. 10

# Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5298587 A
- US 5718967 A
- WO 0209891 A1
- WO 0210473 A1
- EP 0451618 A1
- WO 03014415 A
- WO 194448 A
- DE 10224934
- WO 03015122 A

**In der Beschreibung aufgeführte Nicht-Patentliteratur**

- **Rupertus et al.** *Fresenius J Anal Chem,* 1997, vol. 358, 85-88
- **Erlat et al.** *J. Mater. Res.,* 2000, vol. 15, 704-716
- **Erlat et al.** *J. Phys. Chem. B,* 1999, vol. 103, 6047-6055
- **M. Walther ; M. Heming ; M. Spallek.** *Surface and Coatings Technology,* 1996, vol. 80, 200
- *J. Vac. Sci. Technology,* 2001, vol. A19, 2320
- **Yasuda et al.** *J. Polym. Sci., Polym. Chem. Ed.,* 1978, vol. 16, 743